# EUROPEAN PATENT APPLICATION

(11) **EP 0 793 405 A2**
(43) Date of publication of application: **03.09.1997**
(21) Application number: 97301300.6
(22) Date of filing: 27.02.1997
(51) Int. Cl.: H05K 1/09, H05K 3/40, H05K 3/46

(54) **Multilayer electronic assembly utilizing a sinterable composition and related method of forming**

(30) Priority: 28.02.1996 US 608178
(71) Applicant: CTS Corporation, Elkhart Indiana 46514 (US)
(72) Inventor: Ernsberger, Craig N., Granger, Indiana 46530 (US); Leach, Sarah E., Elkhart, Indiana 46517-3503 (US); Allen Kathleen E., Granger,Indiana 46530 (US); Wenzel, Ralph J., Osceola. Indiana 46561 (US); Meyer, Richard C., Elkhart. Indiana 46516 (US)
(74) Representative: Rees, David Christopher

(57) **Abstract**

Electronic assemblies comprising a sinterable composition are disclosed. The composition sinters reactively and/or non-reactively during the lamination cure cycle of the assembly. The composition generally comprises (i) at least one high melting particulate phase material, (ii) at least one low melting material, and (iii) an organic portion comprising a resin and a cross-linking agent.

## Description

This invention pertains to single and multilayer electronic interconnect assemblies, methods of forming such assemblies, and methods of forming electrically conductive vias in laminates by utilizing a novel sinterable composition that forms a robust electrical via during lamination.

Multilayer electronic assemblies are of great importance in the electronics industry where space is at a premium. Such assemblies typically comprise two or more dielectric substrates having electrically conductive circuitry, separated from each other by one or more dielectric layers. The electrically conductive layers of the assembly are electrically connected at discrete locations within the assembly through electrically conductive vias. The vias extend perpendicular to and between the electrically conductive layers or circuitry, and thus, extend through one or more dielectric layers.

Substrate layers having electronic circuitry disposed on one or both faces of the substrate and further having one or more electrically conductive vias extending through the thickness of the substrate are known. The vias or holes extending through the dielectric can be made electrically conductive through a variety of techniques. A common technique employed with organic laminate based circuit boards is to produce a plated through hole in the multilayer structure wherever a via from one layer to another is required.

Although used in the majority of multilayer interconnect assemblies, there are a number of disadvantages associated with conventional plated through holes. A first drawback is the area of the board that a plated through hole occupies. Plated through holes are typically produced by drilling a hole through a multilayer board and then metallizing the hole with copper by electroless and electrolytic plating. It is difficult to drill and plate a small via through the relatively thick multilayer structure. It is also difficult to register the drill to the "capture pad" required to connect the through hole to the desired electrically conductive traces in the assembly. These combined difficulties result in relatively large via and capture pad structures. Typical sizes are 300 micron holes in 450 micron capture pads. Smaller sizes are possible at significant cost penalties.

A reduction in the area of the circuit board occupied by vias and capture pads may be achieved by the use of blind and buried vias. As will be understood by those skilled in the art, blind vias are vias which extend from one exposed face of the multilayer.assembly to a location within the interior of the assembly. Buried vias are vias which extend from a first interior location within the assembly to a second interior location within the assembly. In order to form a multilayer assembly having electrically conductive blind or buried vias using plated via techniques, it is necessary to perform a relatively complicated sequential lamination procedure. Such procedure is time consuming and costly. Moreover, sequential lamination processes are undesirable since such techniques subject the initial assembly, or components thereof, to a large number of lamination cycles typically involving high temperatures. Furthermore, such exposure can adversely affect the physical and electrical integrity of the initial assembly.

Prior artisans have developed many approaches to fabricating multilayer electronic interconnect assemblies with blind and buried vias. Some share the above-mentioned disadvantage of sequential processing. These approaches include multilayer thick film processes that successively deposit dielectric material and electrically conductive material followed by a firing or curing step. These steps are then repeated to sequentially build a multilayer structure with blind and buried vias. This approach has been practiced with both metal/ceramic (cermet) materials as well as metal/polymer (polymer thick film) materials. More recently, sequential processes have been developed based on deposition of dielectric followed by development of vias in the dielectric by several means including blind laser drilling, plasma or chemical etching, photo imaging and other techniques known in the art. Once formed, vias and metal circuit traces are formed by any of several available means such as vapor or liquid phase metal deposition techniques such as evaporation, sputtering, electroless and electrolytic plating. Additional layers require the repetition of these dielectric deposition, via formation, and metal deposition steps.

All of the above techniques for producing multilayer electronic interconnect structures with blind and buried vias suffer from sequential processing that reduces yields and raises costs. Prior artisans have developed a parallel processing technique that overcomes some of the difficulties encountered with the above-mentioned sequential processing techniques. This process is known to those skilled in the art as the multilayer cofire ceramic process. This process begins with a "green" sheet comprised of various glass and ceramic particles and a small amount of organic "binder" material to provide mechanical support in the unfired sheet. Vias are formed in this green sheet and then the vias are filled with a cermet type composition. Circuit traces are then printed on the sheets with a similar cermet type composition. Similarly prepared green sheets with the required pattern of circuit traces and vias are then stacked and laminated together in the proper sequence and registration required by the final multilayer structure. During a final high temperature firing step the cermet materials comprising the vias and circuit traces and the various glass and ceramic particles comprising the dielectric portion of the assembly sinter together to form the final assembly. There are several advantages to this approach. First, since vias are being formed in relatively thin sheets of material, via and capture pad diameters can be much smaller than plated through hole structures. More importantly, because of the parallel nature of the process, blind and buried vias are easily obtained. Sequential processes and poor yields are entirely avoided. Finally, the ceramic structure is very robust and is suitable for high reliability applications and demanding environments.

Unfortunately, there are also disadvantages to the cofire ceramic process. First, because of the necessity to sinter relatively refractory materials such as glass and ceramic, very high firing temperatures are involved. This places limitations on the conductive materials that can be utilized. The high firing temperature also contributes to the high cost of this process. Secondly, the dielectric constant of the glass and ceramic is higher than that found in typical laminated multilayer circuit boards. The combination of relatively high resistance conductors and high dielectric constant dielectric results in limitations in the electrical performance of cofire ceramic boards. Thirdly, because of the high firing temperature, all of the organic binder originally present in the precursor conductor and dielectric material must be removed by a controlled "burn out" step prior to the final high temperature sintering process. This adds to process difficulty and results in a very significant shrinkage of the assembly during firing. Control of the shrinkage factors in different types and lots of materials is very challenging and contributes significantly to the cost and complexity of the cofire process.

Attempts have been made to obtain the benefits of a parallel process like cofire ceraic without incurring the disadvantages listed above. Thus, one approach has been to fill vias in organic based boards with metal filled polymers similar to the polymer thick film materials previously described. The filled structures are then laminated together to form multilayer structures. Because of the parallel process blind and buried vias are easily obtained. As in cofire ceramic, the vias and capture pads can be much smaller than plated through hole structures and much board space is saved as a result. High temperature processes and the associated shrinkage problems that exist with cofire ceramic are avoided. Lower resistance conductors and lower dielectric constant dielectrics also contribute to better electrical performance in the organic based materials.

In spite of these advantages, metal filled polymer vias are difficult to produce with low electrical resistance, high yield and good environmental stability. The polymer component in such filled vias is not electrically conductive. Instead, conductivity occurs as a result of points of contact between individual metal filler particles. Even silver filler particles are not entirely corrosion and contamination resistant, and may further be sensitive to moisture and handling.

Point contact must also be established between the via particles and the planar circuitry patterns of each layer. This point contact is adversely affected by thermally or mechanically induced physical motion. Poor point contact with the planar patterns results in increased electrical resistance through the via, just as if the via material itself had high electrical resistance. Point contact simply does not offer the electrical conductivity and reliability of solid metal conductors. In short, these metal filled polymer multilayer structures are simply not reliable and are not used in the industry for applications which demand reliability.

Thus, there is still a need for a relatively low temperature and low cost parallel process capable for forming reliable, small blind and buried vias in organic based multilayer structures. What has been missing to date and what is provided for in the present invention is a via fill material that is capable of forming the same type of stable, low resistance sintered microstructure found in cofire ceramic vias, at temperatures and pressures consistent with organic based laminates. In addition, the new via fill material does not undergo any significant shrinkage during the sintering process. The net result is a highly reliable, dense, and cost effective multilayer interconnect structure based on organic laminate materials.

In addition, the new via fill materials allow for entirely new approaches to flip chip die attach and other electronic assembly processes. Present flip chip processes begin by "bumping" the input\output pads on the die with a solder ball. The die is flipped upside down with the active face of the die with its associated solder bumps facing and registering to attachment pads on the next level of packaging, typically a circuit board or single or multi chip module. Thus mounted, the assembly is exposed to a time and temperature profile sufficient to reflow at least a portion of the solder on the die or the board pads. Upon cooling, a metallurgical connection between the die and the board pads is obtained. If a reliable connection is to be obtained when attaching flip chips to organic based boards, the solder bumps must additionally be encapsulated with a thermoset or thermoplastic material that can accommodate the stresses associated with the difference in thermal coefficient of expansion of the silicon die and the organic board. This organic "underfill" is conventionally applied in liquid form after flip chip attach. The underfilled assemblies are then subjected to a post cure. Although satisfactory in most respects, currently known methods for flip chip die attach and related assemblies are relatively time consuming and costly. The present invention provides a new approach for electrically connecting and physically attaching a flip chip to a substrate or circuit board.

The present invention achieves the above-noted objectives and provides compositions particularly adapted for forming electrically conductive vias in laminated electronic substrates and assemblies. The compositions generally comprise (i) at least one high melting particulate phase material, (ii) at least one low melting material, and (iii) an organic portion comprising a resin and a cross-linking agent.

The preferred embodiment compositions have unique processing characteristics such that they sinter to dense, very conductive microstructures during exposure to time, temperature, and pressure profiles consistent with the lamination of organic based materials. The compositions of the present invention form a transient liquid phase and/or reactively sinter during processing which leads to the formation of a superior electrically conductive material. Preferred embodiment compositions also feature particular proportions of each component and the use of specific combinations of components.

The present invention provides electronic assemblies comprising the above-described compositions in both the unsintered and sintered state. In particular, multilayer electronic assemblies are provided comprising a plurality of substrates and/or other layers in a stacked configuration in which vias or apertures in the substrates or layers are filled with the compositions of the present invention.

Also provided are processes for forming the electrically conductive pathways and related assemblies comprising such vias.

The invention may be carried into practice in various ways and some embodiments will now be described by way of example with reference to the accompanying drawings, in which:-
FIG. 1 is an exploded view of a partially assembled preferred embodiment multilayer electronic assembly according to the present invention;
FIG. 2 is an exploded view of the preferred embodiment multilayer assembly of FIG. 1 having capture pads disposed on circuit boards and interposer layer vias filled with the composition of the present invention;
FIG. 3 is an exploded cross-sectional view of the assembly of FIG. 2;
FIG. 4 is an exploded view of another partially assembled preferred embodiment multilayer electronic assembly according to the invention;
FIG. 5 is an exploded view of the preferred embodiment multilayer assembly of FIG. 4 having circuit board vias and interposer layer apertures filled with the composition of the present invention;
FIG. 6 is an exploded cross-sectional view of the assembly of FIG. 5;
FIG. 7 is a cross-sectional view of a single circuit board having a plated via;
FIG. 8 is a cross-sectional view of the plurality of boards and interposers shown in FIGS. 4-6 laminated together;
FIG. 9 is a partial view of a multilayer electronic assembly, illustrating in detail electrical pathways formed by filled vias and filled apertures according to the present invention;
FIGS. 10a to 10e illustrate an etched cladded laminate assembly and its assembly according to the present invention;
FIGS. 11a to 11f illustrate a method of fabricating a multilayer electronic assembly from single sided assemblies with one possible version of filled vias according to the present invention;
FIGS. 12a to 12f illustrate a method of fabricating a multilayer electronic assembly from single sided assemblies with another possible version of filled vias according to the present invention;
FIG. 13 illustrates a multilayer assembly formed from a plurality of circuit boards or substrates, each having circuitry disposed on both faces, and utilizing plated vias according to the present invention;
FIG. 14 illustrates a multilayer assembly formed from a plurality of circuit boards or substrates, each having circuitry disposed on both faces, and utilizing closed plated vias according to the present invention;
FIG. 15 illustrates a multilayer assembly formed from a plurality of circuit boards or substrates, each having circuitry disposed on both faces, and utilizing blind filled vias according to the present invention;
FIG. 16 is an exploded view of an electronic component electrically connected and physically affixed to a substrate by a direct chip attachment technique in accordance with the present invention;
FIG. 17 is an exploded detail view of a variant embodiment for providing electrical connection between capture pads in an electronic assembly according to the present invention;
FIG. 18 is a micrograph illustrating an electrically conductive microstructure in accordance with the present invention;
FIG. 19 is a micrograph of a filled via produced in accordance with the preferred embodiment process of the present invention; and
FIGS. 20a and 20b illustrate by micrograph another filled via produced in accordance with the preferred embodiment process of the present invention.

The present invention provides sinterable compositions for use in single and multilayer electronic assemblies, manufacturing such assemblies, and forming electrically conductive vias or pathways, particularly in layered assemblies. The term "single layer electronic assembly" as used herein refers to electronic assemblies, components, or portions thereof which generally consist of a single or unitary layer or substrate. Thus, that term encompasses single layer circuit boards as well as single layer interposers defined later herein. Accordingly, the term "multilayer electronic assembly" as used herein refers to electronic assemblies, components, or portions thereof which generally consist of a plurality of substrates or layers. That term encompasses layered assemblies comprising two or more circuit boards, substrates, interposers, or other layers or films.

The present invention provides compositions which sinter in the presence of a liquid phase or reactively sinter with or without the presence of a transient liquid phase formed during lamination. The resulting material is electrically conductive and finds wide application, particularly as a via fill material, in the aforementioned structures. The preferred compositions of the present invention are reactively sinterable such that two or more reactive constituents in the composition form an intermetallic compound. The most preferred compositions of the present invention are reactively sinterable such that the reactive constituents form a finely divided, relatively homogenous and continuous microstructure that is substantially all intermetallic or other reaction product. The compositions of the present invention comprise (i) a high melting particulate phase material, (ii) a material that is lower melting and/or reacts with the high melting material, and (iii) an organic portion.

The first component is a relatively high melting particulate phase.material. The term "high melting" refers to materials having a melting point such that the material remains solid at the highest processing temperature or anticipated use temperature which the circuit or assembly will encounter. The highest processing temperature of the preferred embodiment process described later in this disclosure occurs during either lamination of multilayer assemblies or subsequent assembly processes. Lamination temperature is from about 20°C to about 400°C depending on choice of materials. Using the most preferred composition containing copper and tin and lead, lamination temperature is between about 180°C and 325°C depending upon the choice of dielectric materials in the electronic assemblies. The first component material must be capable of at least one of the following: (1) sintering to itself and circuit metallization in the presence of a liquid phase at or below expected lamination temperatures; and/or (2) reactively sintering with one or more components of the low melting material, either in the solid state or in the presence of a transient liquid phase containing the low melting material, as described in greater detail below.

Suitable materials for use as the high melting particulate phase material include all metals from group 3A to 6B of the periodic table excluding Hg, Ga and In. Preferred materials include copper, nickel, gold, silver, and combinations thereof. The most preferred material is copper or copper bearing alloys.

It has been found that it is preferred to utilize the first component in a particulate form. If the composition is to be deposited into a via, the maximum particle size may depend upon the diameter of the via. However, typical particle sizes range from about 1 to about 150 microns. The preferred particle size is from about 0.5 microns to about 15 microns. The most preferred particle size ranges from about 1 to about 6 microns with a median particle size of about 3 microns.

A wide variety of particle shapes may be utilized for the high melting particulate phase material such as for instance, but not limited to spherical, flake, or irregular. Spherical is the preferred shape since such particle geometries promote high loading levels which in turn promote the formation of dense and electrically conductive microstructures.

The second component, the low melting material, is preferably selected such that it forms a transient liquid phase during lamination in the preferred embodiment process described below. The liquid must at least partially wet the previously described first component. Formation of this transient liquid phase is generally a nonreversible process occurring once the composition is at a high enough temperature to melt or partially melt the low melting material. The liquid phase promotes sintering to thereby form the resulting microstructure described in greater detail below. Alternatively, the second component may be selected to reactively sinter with the first component in the solid state.

Representative materials for use as the low melting material include metals and alloys set forth below in Table 1. The preferred class of materials for use as the second component are tin or tin bearing alloys. An example of such an alloy is a eutectic mixture of tin and lead, i.e. a 63 wt% tin/37 wt% lead alloy. When combined with copper, i.e. the most preferred high melting particulate phase material, intermetallic/intermetallic, copper/copper, and copper/intermetallic bonds may form depending on the relative proportions of material, the particle sizes, and the time-temperature-pressure profile to which the material is exposed.

**TABLE 1**

| ALLOY OR METAL | °C | ALLOY OR METAL | °C | ALLOY OR METAL | °C |
|---|---|---|---|---|---|
| Sn Ga | 20 | In Ga | 16 | Ga Zn | 25 |
| Ga | 30 | Sn Pb Bi In Cd | 46.5 | Sn Pb Bi In | 58 |
| Sn Bi In | 61 | Sn Pb Bi Cd | 70 | Bi In | 72.4 |
| Sn Bi In | 79 | Pb Bi Cd | 91.5 | Sn In Cd | 91 |
| Sn Pb Bi | 95 | Sn Bi Cd | 103 | Sn In | 117 |
| Pb Bi | 125 | In Cd | 127 | Sn Bi | 139 |
| Bi Cd | 144 | Sn Pb Cd | 145 | In | 157 |
| Sn Tl | 170 | Sn Cd | 176 | Sn Pb Ag | 178 |
| Sn Zn | 198 | Pb Au | 215 | Sn Ag | 221 |
| Sn | 232 | Pb Cd | 248 | Pb Sb | 251 |
| Cd Zn | 266 | Bi | 271 | Au Sn | 280 |
| Pb As | 288 | Pb Ag | 304 | Pb Zn | 318 |
| Cd | 321 | Au Ge | 356 | Au Si | 370 |
| Sn Pb | 183 | | | | |

When utilizing copper or a copper bearing alloy as the high melting particulate phase material, the following representative elements may be utilized as components in the low melting component: dysprosium, erbium, europium, gallium, gadolinium, germanium, hafnium, mercury, indium, lanthanum, magnesium, neodymium, phosphorus, palladium, praseodymium, platinum, sulfur, selenium, antimony, silicon, samarium, tin, strontium, tellurium, thorium, titanium, thallium, yttrium, ytterbium, zinc, zirconium, and combinations thereof.

A most preferred microstructure is one such that the continuous conductive phase is comprised entirely, or substantially of, all intermetallic bonds. Formation of such a microstructure is promoted by one or more of the following practices: utilizing relatively fine particle sizes for the first and second components, utilizing particular ratios of the first and second components, exposing the composition to a particular temperature for a sufficient amount of time, ensuring the concentrations of the metallic components are such that an acceptable metal loading level is reached, and subjecting the composition to a compressive pressure.

In the previously described copper, tin, and lead system, the metal system undergoes transient liquid phase sintering during processing above 183°C. Transient liquid phase sintering is defined herein as heating a system comprising two or more metallic particulates to the melting point of one or more of the metallic particulates followed by consumption of the resulting liquid phase through diffusion alloying with a still solid higher melting metallic particulate. The resulting sintered structure is solid even at the original melting temperature of the low melting particulate.

As with the first component, it has been found beneficial to employ the second component in particulate form. If the composition is to be deposited within a via, the allowable particle size for the second component is limited by the size of the via. The particle size for the second component typically ranges from about 1 to about 150 microns. The preferred range for the particle size of the second component is from about 1 to about 20 microns. The most preferred size for the second component particles is from about 1 to about 10 microns.

The ratio of the first component to the second component depends upon the specific materials utilized for each component. The ratio is selected to promote the formation of intermetallic compounds within the resulting microstructure. Typically, this ratio will correspond to the molar ratios of the reactive constituents in the desired intermetallic compound. However, ratios greater than and less than such ratios can also be utilized. An example of a most preferred metallic system comprising copper for the first component and a eutectic mixture of tin and lead for the second component preferably utilizes those first and second components in particular ratios to one another to promote the formation of a copper-tin intermetallic compound. A Cu-Sn phase diagram illustrates that two possible intermetallic compounds may exist at room temperature: Cu₃Sn and Cu₆Sn₅. The corresponding molar ratios of copper to tin in these compounds are 3:1 and 1.2:1, respectively. Accordingly, in the example of a most preferred metallic system comprising copper and tin, the ratio of the first component to the second component is selected such that the molar ratio of copper to tin ranges from about 3:1 to about 1.2:1.

The third component, an organic portion, is a space-filling, mechanical property enhancing material that occupies the interstices of the metal network of the conductive composition. This third component generally comprises one or more resins, at least one curing or cross-linking agent, an optional fluxing agent, and one or more optional rheology agents. It is generally desirable to include an agent having a fluxing activity. A conventional fluxing agent can provide this activity. It is not necessary to provide a significant amount of fluxing agent. Alternatively, or in addition, the cross-linking agent(s) could provide the desired fluxing activity. Addition of one or more rheology agents is also optional, and generally depends upon specific application requirements. However, such agents may be desired to facilitate subsequent processing such as screen printing. An example of a rheology agent which optionally may be incorporated in the composition of the present invention is a dispersing agent which reduces the viscosity of highly loaded resins.

The third component may be tailored to provide resilience to the resulting structure, thereby lessening the probability of failure. Additionally, the resilience referred to may also provide for better tolerance of thermally induced stress. The third component may also be employed to provide the composition with a coefficient of thermal expansion that is similar to that of the substrate or materials adjacent and proximate the composition when disposed in a via or aperture.

The third component is preferably selected so that the conductive composition is flowable prior to curing or other hardening operation, is stable to other high temperature processes after lamination, not be corrosive after curing or other hardening operation, and undergo curing or hardening at similar temperatures and pressures as other curable materials utilized in electronic assemblies utilizing the compositions of the present invention.

It is important that the organic portion not generate adverse amounts of gases during curing or processing of the composition which would affect the performance or the integrity of the electronic assembly or laminate. It is preferable that the organic component not condense during cure and not contain solvent which would have to be removed prior to lamination. Generation of gases can cause voids or bubbles in the resulting structure of the conductive compositions. Moreover, in multilayered electronic assemblies, generation of gases can cause damage to the laminate structure particularly during temperature increases which cause gas expansion. Thus, one important characteristic of the composition of the present invention, is that it does not generate adverse amounts of gases upon laminating up to about 400°C, the maximum temperature employed in the process of the present invention, at a laminating pressure of at least about 10 psi. This phrase "adverse amounts of gases" refers to an amount of gas which if released from a via or aperture filled with the composition of the present invention, would harm or adversely affect the performance or physical or electrical integrity of an electronic assembly comprising such filled apertures or vias. That phrase also encompasses an amount of gas which if released from a filled via or aperture and if retained within an electronic assembly would harm or adversely affect the performance or physical or electrical integrity of the electronic assembly if such assembly were subjected to temperatures within its expected operating environment.

Preferably, the organic component is a liquid at room temperature, which binds the first and second components and provides a consistency which is satisfactory for screen printing and depositing the resulting composition into vias or apertures of an electronic assembly. As previously noted, the compositions of the present invention include the use of rheology additives to facilitate such operations.

Suitable resins for use as the third component include any resin that can be cross-linked by a curing agent, such as for instance, but not limited to, a metal catalyst, or a hydroxyl group-bearing reagent. Resins which meet this requirement include, but are not limited to, epoxies, phenolics, novolacs (both phenolic and cresolic), polyurethanes, polyimides, bismaleimides, maleimides, cyanate esters, polyvinyl alcohols, polyesters, and polyureas. Other resin systems may be modified to be cross-linkable by a curing agent, for example a metal catalyst, or a hydroxyl group-bearing agent. Examples of such resins are acrylics, rubbers, (butyl, nitrile, etc.), polyamides, polyacrylates, polyethers, polysulfones, polyethylenes, polypropylenes, polysiloxanes, polyvinyl acetates/polyvinyl esters, polyolefins, cyanoacrylates, and polystyrenes. Typically, any resin would be suitable if the resin can be modified to contain at least one of the following functional groups: anhydrides, carboxylic acids, amides, imides, amines, alcohols/phenols, aldehydes/ketones, nitro compounds, nitriles, carbamates, isocyanates, amino acids/peptides, thiols, sulfonamides, semicarbazones, oximes, hydrazones, cyanohydrins, ureas, phosphoric esters/acids, thiophosphoric esters/acids, phosphonic esters/acids, phosphites, phosphonamides, sulfonic esters/acids or other functional groups to act as reactive sites for polymerization. For example, a polyolefin is not a preferred resin since it has no reactive sites for cross-linking and has poor adhesive properties. However, a carboxylated polyolefin would function as a preferred resin when matched with a suitable cross-linking agent. A combination of these and other resins, such as noncross-linkable thermoplastic resins, may also be used. Generally, although a noncross-linkable polymer can be utilized in the compositions of the present invention, it is preferred to exclusively use one or more cross-linkable polymers.

The preferred type of resin is an epoxy. It is preferred to utilize an epoxy-based material for the third component since that material does not generate water or gaseous byproducts during curing. The most preferred type of epoxy is diglycidyl ether of bisphenol A. An example of such a most preferred epoxy-based material is EPON 828 resin, available from Shell Chemical. Other types of epoxies which could be used are epoxy novolacs, multifunctional and cycloaliphatic. Representative examples of specific epoxies by type which could be utilized for the preferred embodiment composition and which are commercially available include, but are not limited to the following: Bisphenol A types of epoxy resins with average molecular weights similar to Shell Epon 828 including Shell Epon 826, Epon 813, Epon 815, Ciba-Geigy Araldite GY6004, Araldite GY6010, Dow D.E.R. 330, D.E.R. 331 and D.E.R. 383. Examples of epoxy novolacs which could be used are Dow D.E.N. 431, D.E.N. 438 and Ciba EPN 1138. Examples of cycloaliphatic epoxies are Ciba CY 179 and CY 184. Examples of multifunctional epoxies are Ciba MY 721 and MY 722.

Suitable epoxy curing/cross-linking agents include acid anhydrides, organic acids, amines, amides, phenolics, and lewis catalysts. Curing agents may be used alone or in combination with other curing agents. Preferably, the curing agent has fluxing activity which becomes inactive once cross-linked. Preferred epoxy curing agents with fluxing capability, referred to herein as "cure/flux" agents, include carboxylic acids and anhydrides. Examples include but are not limited to abietic acid, adipic acid, ascorbic acid, acrylic acid, citric acid, glutamic acid, malic acid, phthalic anhydride and maleic anhydride. Malic acid is the most preferred.

Also preferred is a liquid anhydride co-curing agent. the most preferred liquid anhydride is dodecenylsuccinic anhydride (DDSA). In addition to functioning as a co-curing agent, DDSA reduces the viscosity of the composition and contains a long aliphatic chain which imparts flexibility to the cured system. Other examples of liquid anhydrides which can be used include methyltetrahydrophthalic anhydride (MTHPA) and methylhexahydrophthalic anhydride (MHHPA).

As previously noted, it is important that the first and second components be selected such that the first component is readily wetted by or reacts with the second component. For those combinations of components in which such wetting or reaction does not readily occur or needs to be further enhanced, it is possible to pre-treat the high melting particulate phase first component to promote wetting or reaction by the low melting second component. Typical pretreatments include chemical etching, heat treatment in a reducing environment, and plasma etching. It is also contemplated to coat the high melting material with the low melting material.

In forming the conductive composition of the present invention, it is preferred to form an organic portion comprising the previously described third component, i.e. one or more resins, and at least one curing or cross-linking agent, an optional fluxing agent, and an optional rheology additive. The organic portion is then mixed with appropriate amounts of the first and second components. Table 2, set forth below, provides the allowable and preferred proportions of the various ingredients constituting the organic portion of the composition of the present invention.

**TABLE 2**

| Component (wt. %) | Allowable (wt. %) | Preferred (wt. %) |
|---|---|---|
| Resin | 1-98 | 46-69 |
| Curing Agent | 1-60 | 17-46 |
| Cure/Flux Agent | 0-60 | 9-13 |
| Rheology Additives | 0-10 | 0.5-5 |

Table 3, set forth below, provides allowable concentration ranges of components in the composition of the present invention. Table 3 also sets forth preferred and most preferred concentration ranges for the first and second components, and the organic portion for a system comprising copper for the first component, and a 63 wt% tin/37 wt% lead alloy as the second component.

**TABLE 3**

| Component | Allowable Wt. % | Preferred Wt. % | Most Preferred Wt. % |
|---|---|---|---|
| High melting particulate phase | 2-90 | 10-90 | - |
| Copper | 2-90 | 10-90 | 17.48 - 47.74 |
| Low melting particulate phase | 4-93 | 10-90 | - |
| 63 wt% tin/37 wt% lead alloy | 4-93 | 10-90 | 37.31 - 72.85 |
| Organic Portion | 1-35 | 3-30 | 5 - 25 |

The weight percent values listed in the most preferred column of Table 3 correspond to copper and tin molar ratios of from 3:1 to 0.9:1. The lowermost ratio of 0.9:1 is less than the molar ratio of 1.2:1 for the previously discussed most preferred metallic system comprising copper and tin. The reason for this is that in many applications, it is particularly desirable to provide an excess of tin to react with any copper present on circuit traces, capture pads, or interior walls of plated vias.

Another preferred formulation for the sinterable composition of the present invention comprises 21-26% by weight copper particles having an average particle diameter of from about 1 to about 6 microns, 61-68% by weight of eutectic tin/lead alloy particles having an average particle diameter of from about 1 to about 10 microns, and 10-14% by weight of an organic portion comprising 59% EPON 828 resin, 30% DDSA, and 11% malic acid.

A wide array of additives and other components may be added to the composition of the present invention. Solvents may be added to lower the viscosity of the composition to facilitate processing. However, any added solvents should be removed prior to lamination. Examples of suitable solvents include, but are not limited to, butyl carbitol acetate, benzyl alcohol, butyl cellusolve, and butyl carbitol. If the solvent evaporates or generates off-gases at temperatures less than the maximum processing or application temperature in the preferred embodiment process described below, the solvent must be removed. It is preferred however, that such solvents not be used. Reactive diluents may be added to reduce viscosity and increase flexibility. Examples include aliphatic glycidyl ethers or reactive epoxy flexibilizers. Additives may be used to affect rheology, mechanical properties, dimensional stability or to aid in dispersing.

The preferred compositions of the present invention provide a low resistance, relatively homogenous fine microstructure by utilizing finely divided particles and particular ratios of high and low melting phases. Upon curing, a continuous, electrically conductive intermetallic structure is formed in the composition. The resulting microstructures formed from the present invention compositions typically have electrical resistances less than 50 micro ohm centimeters. It is remarkable that low electrical resistance formulations, such as those of the present invention, can be achieved without incorporating protected curing agents or oxidation resistant particulate phases, or employing rapid rate of rise "spike" temperature profiles. This is believed to result from the pressure employed during lamination. The particular techniques of the present invention enable the use of fine particles without the need for special particle surface treatment such as by plating a low melting tin phase onto a high melting copper phase.

In addition to the previously described compositions, the present invention also provides single and multilayered assemblies utilizing the conductive compositions in both the sintered and unsintered state as an electrically conductive bonding agent. Although the present invention compositions can be employed in bonding applications, such bonding function is ancillary to their primary function, that of providing electrically conductive pathways in substrates and electronic assemblies.

In a preferred embodiment, a multilayer assembly with electrical interconnection in the axis perpendicular to circuit layers is formed by filling vias in circuit boards, and/or apertures in one or more interposer layers, described below, and performing a single lamination operation with the previously described compositions. The term "aperture" as used herein generally refers to a via in an interposer layer, and so, is used interchangeably with "via" herein. Although it is preferred to form the assemblies described herein utilizing a single lamination operation, it is within the scope of the present invention to utilize multiple laminating operations. During lamination, the electrically conductive constituents of the composition form metallurgical bonds and also metallurgically bond to any metal circuit traces or metallized via sidewalls contacting such constituents. The metallurgical bond is superior to point contact conduction achieved with conventional filled polymer materials.

The multilayer structure can be built up from either single sided circuits comprising a conductive layer and a dielectric layer or double sided circuits comprising a dielectric layer disposed between two conductive layers. Double sided circuits typically have metallized throughholes or plated vias connecting one conductive layer to the other. When using double sided circuits, an interposer layer described in greater detail below, is preferably used between the circuits. When using single layer circuits, vias are typically formed by any suitable means, such as drilling, punching, laser drilling or etching in the circuit after an adhesive is applied to the dielectric side of the circuit. Adhesives can be liquid or dry film, thermoplastic or thermoset, and filled or unfilled. The adhesive is preferably expansion matched to copper and the dielectric. Possible dielectrics include those known in the prior art manufacture of additively or subtractively formed circuitry.

The preferred multilayer electronic assemblies of the present invention may utilize one or more interposers, each disposed between adjacent circuit boards. The term "interposer" as utilized herein refers to a sheet-like, relatively planar member. The preferred interposers for use in the multilayer electronic assembly of the present invention have a particular combination of characteristics as follows. The material utilized for the interposer should have a coefficient of thermal expansion similar to other components and materials in the assembly. The material should also cure at relatively low temperatures and at conventional curing parameters. The interposer material should also be suitable for screen printing processing.

The interposer may be formed from a wide array of materials that exhibit the foregoing characteristics. Examples of such materials include, but are not limited to composite laminates of thermosetting polyimide adhesive films on both sides of a dimensionally stable material such as Kapton or Upilex. Other film adhesives include, but are not limited to thermoplastic polyimides, epoxy, acrylic, polyetherimide, cyanate ester, bismaleimide triazine, and bismaleimide/epoxy. The interposer may consist of a thin layer or film of a single material such as a film adhesive without attachment to a dielectric core layer. Examples of suitable organic film adhesives include DuPont Pyralux, LF 111, Roger's Flex-i-mid 3000, Courtauld's CFK 111, Ultem, Sheldahl MKC 111, DuPont KJ, and Nippon SPB series bondply materials. A preferred interposer is formed from an adhesive film of thermosetting polyimide on both sides of Kapton. Interposers may also be formed from various reinforced materials. Such reinforced materials generally provide improved dimensional stability or thermal conductivity. Common reinforced materials include glass or Aramid™ fiber reinforced epoxy or polyimide. Examples of suitable commercially available reinforced materials include, but are not limited to, FR4 glass reinforced epoxy prepeg and DuPont Thermount products.

The typical thickness for the interposer layer generally ranges from about 0.002 inches to about 0.005 inches. Greater or lesser thicknesses may be utilized depending upon the end-use application and the specific electrical properties desired.

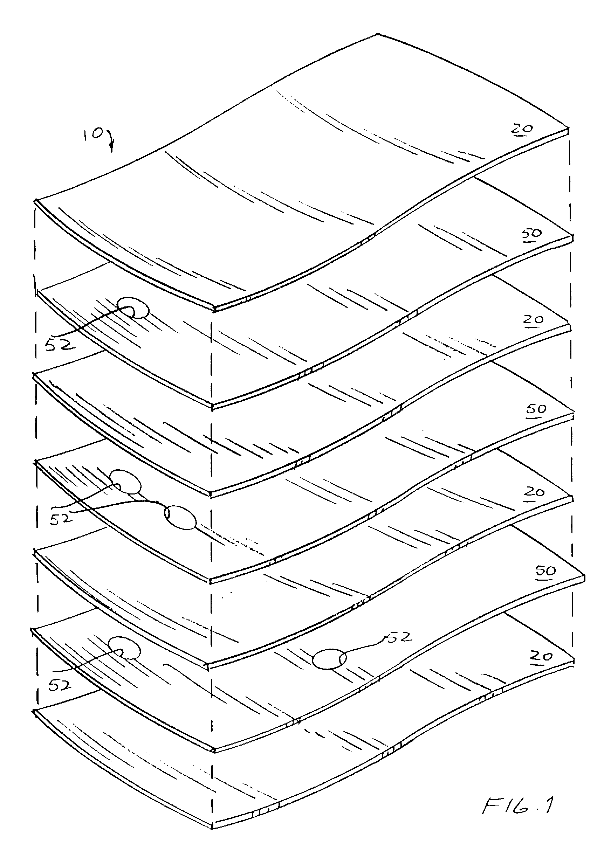

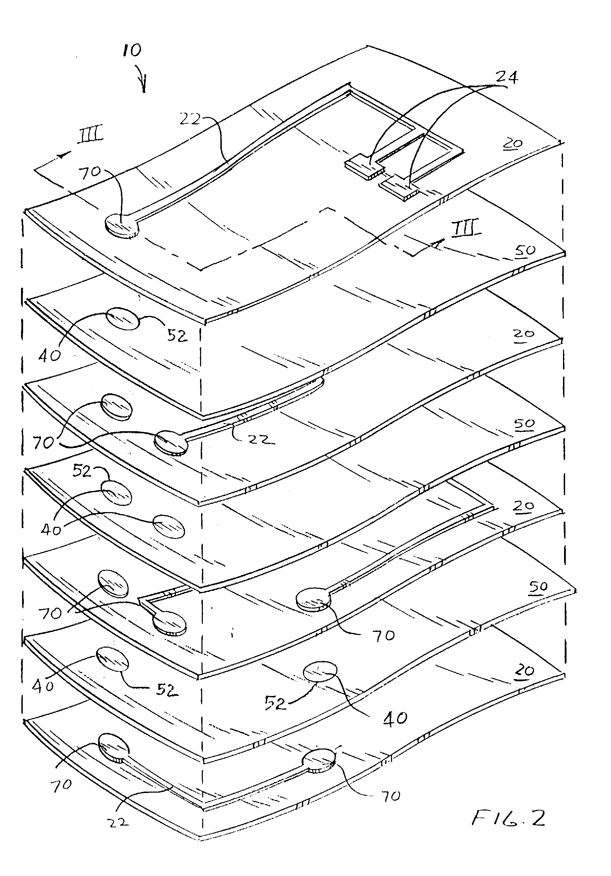

FIGS. 1-3 illustrate a preferred embodiment multilayer electronic assembly 10 comprising a plurality of boards 20 and a plurality of interposer layers 50 disposed between each board 20 in a stacked array. It will be understood that none of the figures referenced herein is to scale. FIG. 1 illustrates a partially constructed assembly 10. FIG. 1 further illustrates the alternating configuration of boards 20 and interposers 50. Defined in one or more interposers are apertures 52. FIG. 2 shows assembly 10 further comprising one or more circuit traces 22, electrical components 24, and one or more capture pads 70, disposed on boards 20. The term "capture pad" as used herein refers to a region or portion of an electrically conductive circuit trace or distal end thereof which is, or will be, in electrical association with an electrical pathway provided for example by a via filled with the composition of the present invention, a circuit trace, or some other component of the electronic assembly. Such capture pads may be in the form of an electrically conductive ridge or annular ring disposed around the opening of a via, or an enlarged terminal end of a circuit trace such as in the shape of a circle or oval.

With further reference to FIG. 2, preferably disposed within each of apertures 52 is the electrically conductive composition 40 of the present invention. Capture pads 70 are preferably located on board 20 so that when the stacked assembly 10 is formed, a filled aperture is disposed between two capture pads 70, such as on two boards 20 adjacent the particular interposer layer. Capture pads 70 primarily serve to electrically bridge a circuit trace on a first board 20 to a filled aperture residing within an interposer layer. A corresponding pad 70, disposed on an adjacent second board 20 on the opposite side of interposer 50, electrically connects other traces or components to the filled aperture and hence, to the trace on the first board.

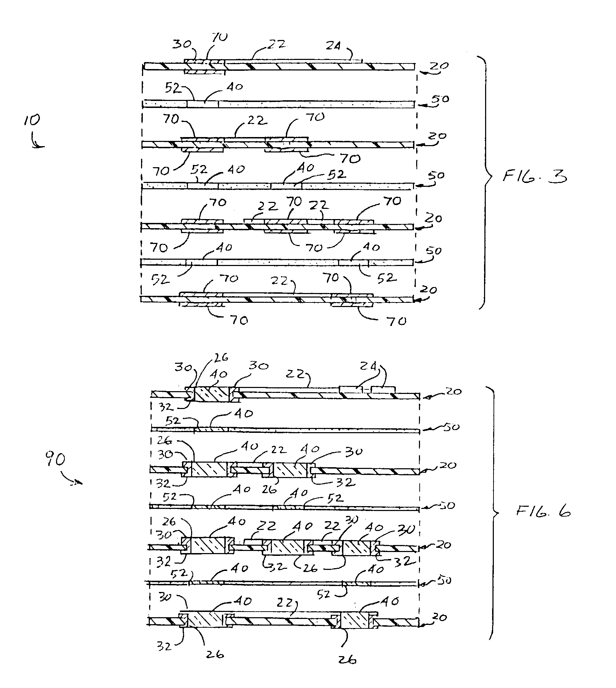

FIG. 3 is a cross-section of the assembly depicted in FIG. 2, and illustrates alignment of capture pads 70 on boards 20 and filled apertures 52 in interposer layers 50. It will be understood that the circuit boards 20 illustrated in FIGS. 2 and 3 have circuit traces 22 and/or electrical components 24 on their undersides.

It may in some instances be preferred to provide plated vias in boards 20. Plated vias comprise an electrically conductive wall extending along the interior periphery of the via. Preferably, the electrically conductive wall extends over the entire length of the via, from one side of board 20 to the other side. It may also be preferred to provide an electrically conductive ridge or capture pad on each side or face of a board, extending around a plated via, and in electrical association therewith. The term "plated via" as used herein encompasses vias having electrically conductive walls that are formed by methods in addition to plating processes.

Since the objective in designing most multilayer electronic assemblies is miniaturization, vias formed in circuit boards advantageously have very small diameters. Accordingly, when plating an electrically conductive wall material within a via, it is possible for such vias to become "closed". For such closed vias, it is not necessary to attempt to further fill with the composition of the invention. For plated vias that are not closed, the composition of the invention may be deposited therein.

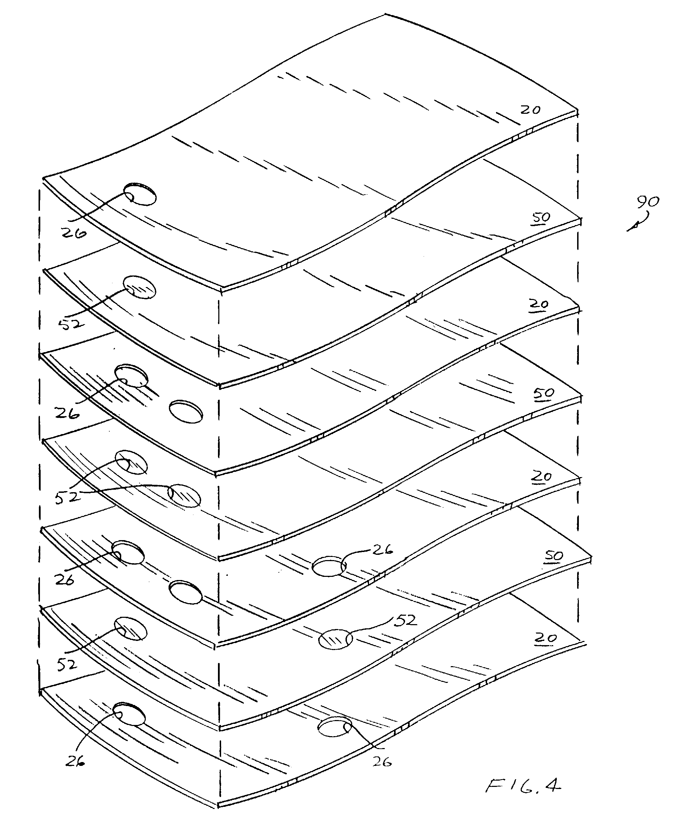

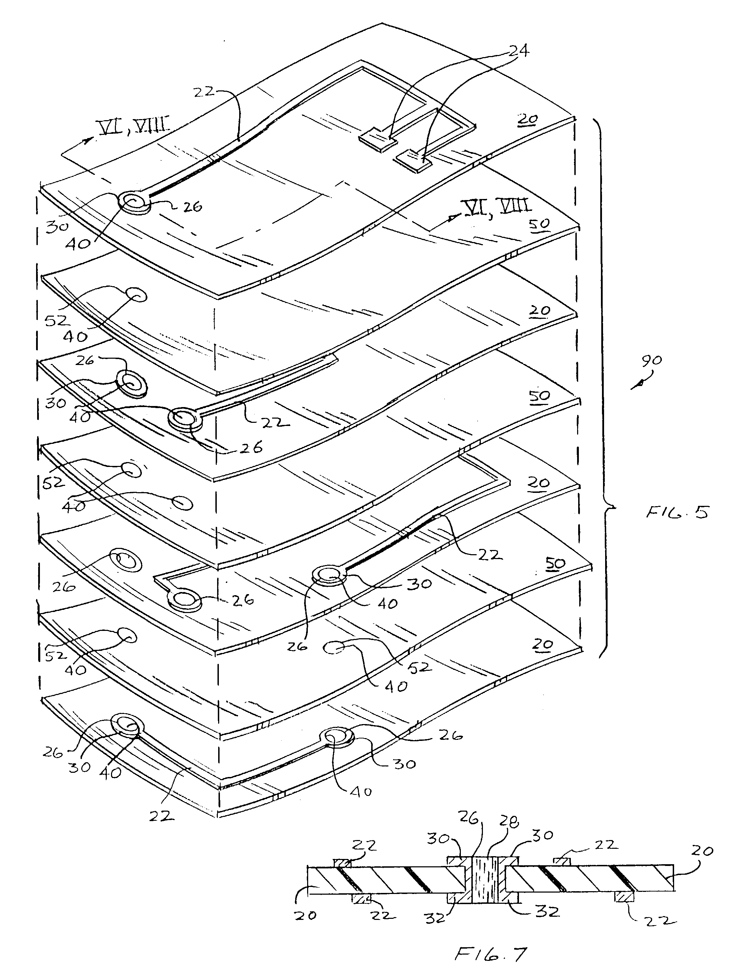

FIGS. 4-6 illustrate, in exploded views, another preferred embodiment multilayer electronic assembly 90 comprising a plurality of boards 20 and a plurality of interposers 50 disposed between each board 20 in a stacked array. FIG. 4 illustrates the alternating configuration of boards 20 and interposers 50. Defined in one or more of boards 20 are plated vias 26. Electrically conductive vias, plated or filled for example, provide electrical pathways between opposite faces of a board 20. Defined in one or more of interposers 50 are apertures 52. FIG. 5 depicts assembly 90 further comprising one or more circuit traces 22 and electrically conductive upper capture pad 30 disposed on board 20 around the perimeter of via 26, and a lower electrically conductive capture pad 32 (not shown) on the opposite side of board 20, also extending around the perimeter of via 26. preferably disposed within each of vias 26 and apertures 52 is the composition 40 of the present invention. FIG. 6 is a cross-section of the assembly depicted in FIG. 5.

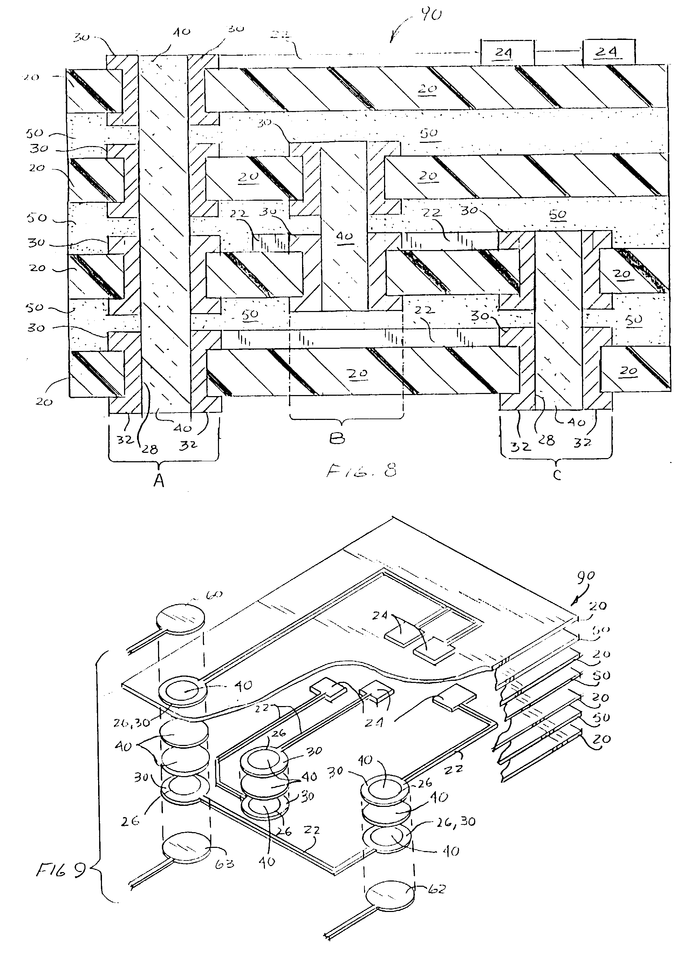

FIG. 7 is a detailed partial cross-section of board 20 from assembly 90 comprising a plurality of traces 22 on both of its faces, and a plated via 26 extending through the thickness of board 20. Disposed on a first face of board 20 is upper conductive capture pad 30, and disposed on a second face opposite the first face, is lower capture pad 32. Disposed along the interior wall of via 26, in electrical association with both upper and lower capture pads 30 and 32, is an electrically conductive wall 28. It is possible to fill plated via 26 with the composition of the present invention, as illustrated in FIGS. 5, 6, 8, and 9.

FIG. 8 is a cross-sectional view of the assembly depicted in FIGS. 4-6 after assembly, i.e. lamination. The resulting collection of aligned filled vias and filled apertures form electrical passageways extending through assembly 90 in a direction perpendicular to the circuit layers. Region A of FIG. 8 depicts a throughhole or passageway extending from one outermost exposed face of assembly 90 to the other outermost exposed face of assembly 90. Residing within the continuous passage formed by vias 26 and apertures 52, all aligned in region A, is electrically conductive composition 40, which provides electrical connection from one side of assembly 90 to an opposite side. Region B illustrates a buried via which, when filled with composition 40, provides electrical connection between interior boards 20, that is boards which are bounded by other boards and so, are not accessible to the exterior of assembly 90. Region C depicts a blind via which, when filled with composition 40, provides electrical connection from the exterior of assembly 90 to electronic traces or components within the interior of assembly 90.

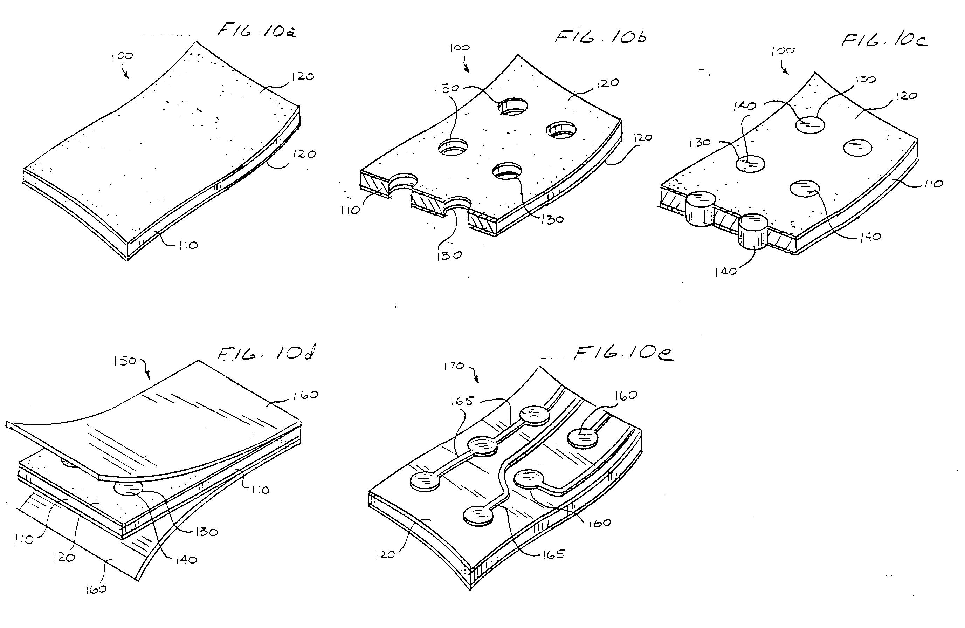

FIG. 9 illustrates electrical pathways formed by aligning vias 26 and apertures 52, filled with electrically conductive composition 40, in multilayer electronic assembly 90. Those skilled in the art will appreciate that FIGS. 8 and 9 are not to scale and that the vias illustrated therein are in practice, significantly smaller than shown. The laminated assembly 90, comprising alternating layers of dielectric boards 20 and interposers 50, is electrically connected to one or more power or signal sources, represented by leads 60, 62 and 63.

It will be appreciated that electrical connections can be established from one region to another in an assembly such as depicted in FIGS. 8 and 9, by utilizing unfilled plated vias. Such vias could also be filled as shown.

The present invention also provides a clad laminate assembly from a bondply sheet or interposer laminate assembly from a composite bondply sheet or interposer layer having one or more filled vias or apertures as illustrated in FIGS. 10a to 10e. Referring to FIG. 10a, bondply 100 comprises a dielectric layer 110 having adhesive layers 120 disposed on opposite sides of dielectric layer 110. It will be understood that only one of many types of bondply configuration has been illustrated and that the bondply may have all possible constructions as previously described herein for interposer layers. FIG. 10b illustrates a plurality of vias 130 defined in bondply 100. Vias 130 extend through the thickness of bondply 100. FIG. 10c illustrates vias 130 filled with an effective amount of the composition of the present invention, designated as 140. FIG. 10d illustrates a cladded laminate 150 comprising the bondply 100 of FIG. 10c having layers of copper cladding 160 disposed on each of its sides. FIG. 10e illustrates an etched cladded laminate 170 formed from cladded laminate 150 of FIG. 10d by selectively etching or otherwise removing regions of copper cladding 160, thereby forming circuits 165.

The electronic assemblies of the present invention are initially constructed by several methods. An electronic assembly can be formed for instance, by (i) utilizing circuit boards having circuitry on only one side, (ii) using circuit boards having circuitry on both sides and using a bondply or interposer layer having one or more vias or apertures filled with the composition of the present invention, or (iii) by utilizing combinations of (i) and (ii).

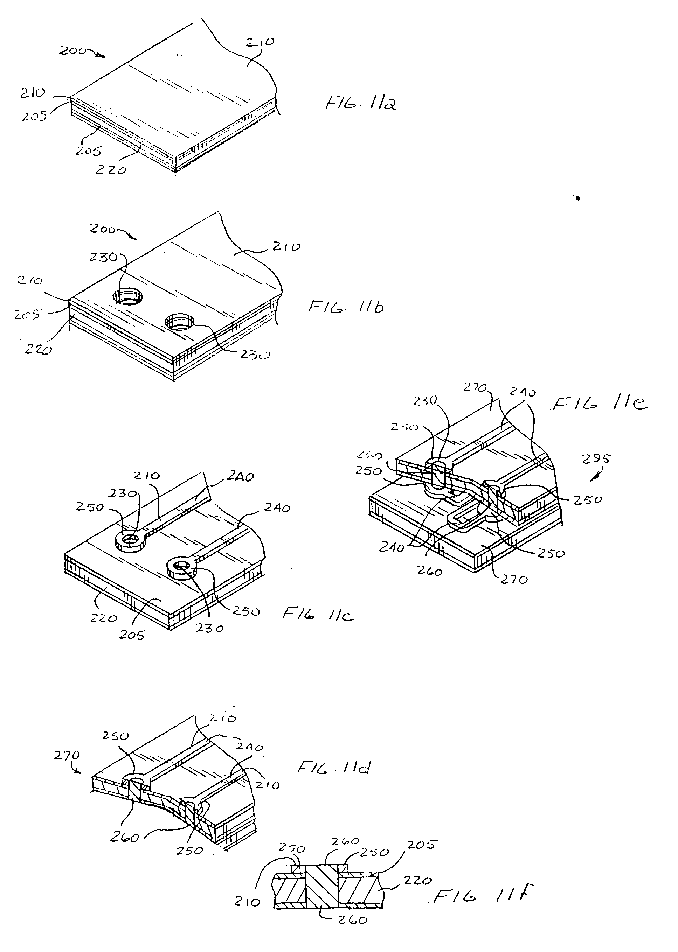

With regard to the first technique (i), FIGS. 11a to 11f illustrate forming a multilayer assembly from single sided boards or substrates while also depicting formation of such assembly providing througholes. FIG. 11a illustrates providing a cladded laminate 200 preferably comprising a sheet of copper cladding 210 disposed on a dielectric layer 220 and affixed thereto by adhesive layer 205. It will be understood that the adhesive layer is optional and that the assembly 210 may also be of various adhesiveless constructions. One or more vias 230 are formed in cladded laminate 200 as shown in FIG. 11b. Appropriate circuitry 240 is formed by selectively removing, such as by etching, regions of copper cladding 210 as shown in FIG. 11c. It is preferred to provide capture pads 250 around the periphery of each via 230, as best illustrated in FIGS. 11c and 11f. The vias 230 are filled by an effective amount of the composition of the present invention, designated in FIGS. 11d, 11e, and 11f as 260. FIG. 11d illustrates a circuit board 270 having circuitry 240 disposed on one side of the board and also having a plurality of filled vias. FIG. 11e illustrates a multilayer assembly 295 formed by stacking a plurality of single sided boards 270 such that circuitry 240 on each board is in electrical association by via 230 filled with composition 260.

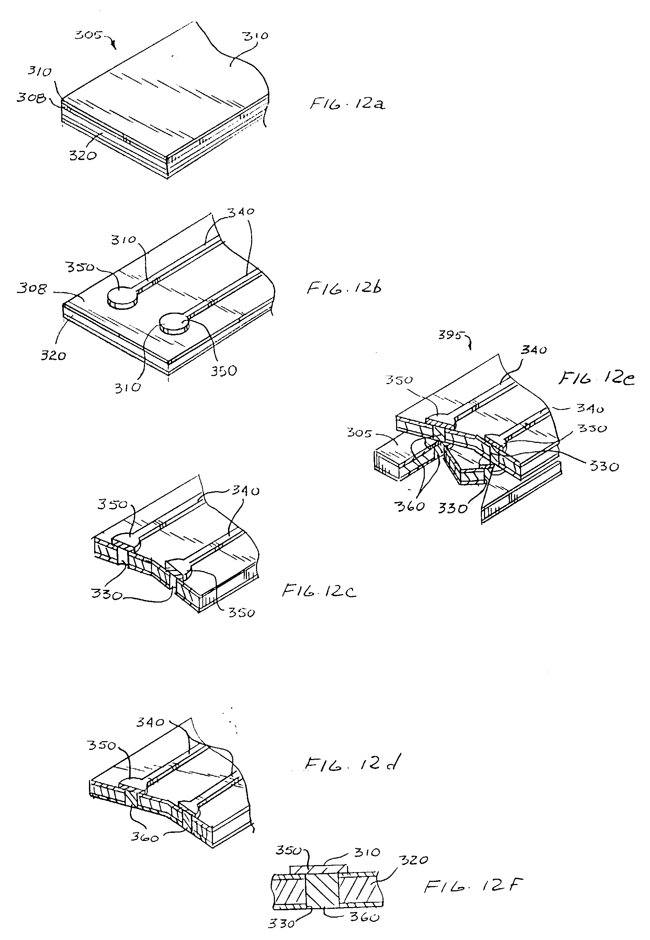

A variation of technique (i) for forming a multilayer assembly from single sided boards is illustrated in FIGS. 12a to 12f. A multilayer assembly 395 constructed according to this scheme comprises one or more blind vias, shown as 330, filled with the composition of the present invention 360. FIG. 12a illustrates a cladded laminate 305 preferably comprising a layer of copper cladding 310 disposed on a dielectric layer 320 and affixed thereto by an adhesive layer 308. It will be understood that the adhesive layer is optional and that the assembly may also be of various adhesiveless constructions. Circuitry 340 is formed by selectively removing, such as by etching, regions of copper cladding 310 as depicted in FIG. 12b. When forming such circuitry, it is preferred to provide capture pads 350 at the location or intended location of a blind via 330, as best shown by FIG. 12f. One or more blind vias 330 are formed in cladded laminate 305 as shown in FIG. 12c. The blind vias 330 are then filled with appropriate amounts of the composition of the present invention, shown as 360 in FIG. 12d. FIG. 12e illustrates the multilayer assembly 395 formed by stacking a plurality of single sided boards 305 such that circuitry 340 on each board is in appropriate electrical association by via 330 filled with composition 360.

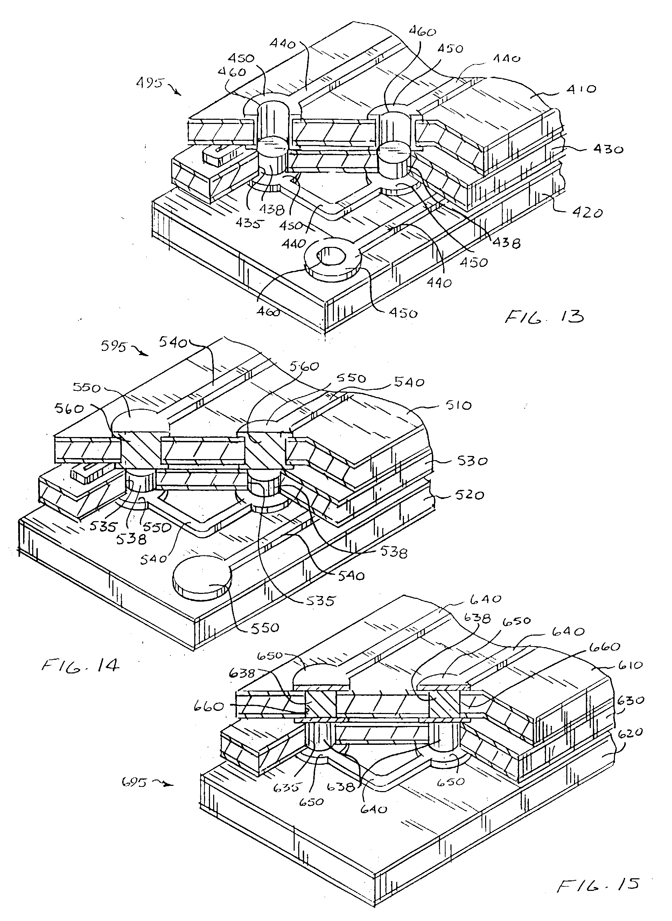

Concerning the second technique (ii) for forming a multilayer electronic assembly from circuit boards having circuitry on both sides, FIG. 13 illustrates a multilayer assembly 495 comprising a first circuit board 410 having circuitry 440 disposed on both its sides, a second circuit board 420 having circuitry 440 disposed on at least one, and preferably both of its sides, and an interposer layer 430 having at least one aperture 435 formed therein and filled with an effective amount of electrically conductive composition of the present invention, shown as 438. Circuit boards 410 and 420 each preferably provide one or more plated vias 460. As previously described, it is preferred to provide capture pads 450 disposed around the periphery of a via 460. It may also be desired to not fill one or more vias 460 provided in boards 410 and 420 as shown in FIG. 13.

In a variation of technique (ii) for forming a multilayer electronic assembly from circuit boards having circuitry on both sides, FIG. 14 illustrates a multilayer assembly 595 formed from circuit boards having closed or plated shut vias. Assembly 595 generally comprises a first circuit board 510 having circuitry 540 disposed on both its upper and lower faces. Circuitry 540 of board 510 preferably terminates at capture pads 550 which are disposed adjacent and in electrical association with a plated shut via 560. Assembly 595 further comprises a second circuit board 520 comprising appropriate circuitry 540 and capture pads 550 disposed on both of its faces. Disposed between first and second boards 510 and 520 is an interposer layer 530 having one or more apertures 535 filled with an effective amount of the electrically conductive composition shown as 538.

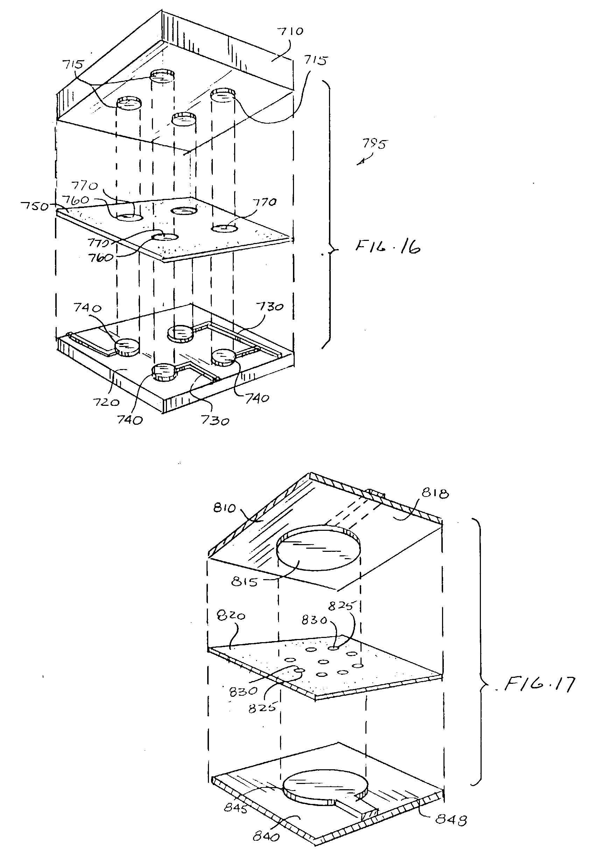

In another variation of the second technique (ii) for forming a multilayer electronic assembly from circuit boards having circuitry on both sides, FIG. 15 illustrates a multilayer assembly 695 comprising a first circuit board or substrate 610 and a second board or substrate 620, each having circuitry 640 disposed on both sides. Circuitry 640 preferably utilizes capture pads 650 that are disposed adjacent and in electrical association with blind vias 660. Assembly 695 further comprises an interposer layer 630 having one or more apertures 635. Preferably, blind vias 660 and apertures 635 are filled with appropriate amounts of electrically conductive composition 638.

Another application of the present invention pertains to direct chip attachment (DCA) techniques. As will be appreciated by those skilled in the art, direct chip attachment methods are known in which an electronic chip or other component having one or more solder points, capture pads, or points of electrical connection on its underside is directly electronically connected to a receiving region on a substrate face. Once electrically connected, a liquid fill material, typically a flowable dielectric adhesive, is injected between the underside of the component and the substrate receiving face. The liquid fill material, upon sufficient curing or hardening, provides or significantly promotes reliability of the assembly during thermomechanical stress such as is encountered in thermal cycling.

As illustrated in FIG. 16, the present invention provides both electrical connection and physical attachment between an electronic chip 710 and a circuit board or other substrate 720 having circuit traces 730 and capture pads 740 disposed on a receiving face of substrate 720. Chip 710 has one or more points of electrical connection 715 disposed on its underside. Interposer 750 comprises one or more apertures 760 filled with an effective amount of electrically conductive composition of the present invention depicted as 770. Direct chip attachment assembly 795 is formed by aligning chip 710, interposer 750, and substrate 720 so that each of points 715 is in electrical association with a corresponding capture pad 740 through a filled aperture 760. After appropriate placement, the resulting assembly is subjected to a heating operation under pressure whereby chip 710 is physically affixed to substrate 720.

In all of the foregoing embodiments, electrical connection from a first capture pad disposed on a face of a circuit board or other substrate and a second capture pad disposed on an adjacent face of another circuit board or substrate can be accomplished by multiple apertures or vias filled with the composition of the present invention. For example, as illustrated in FIG. 17, a first substrate 810 having a capture pad 815 disposed on a face 818 is aligned with an interposer layer 820 having a plurality of apertures 825 each filled with an effective amount of the electrically conductive composition of the present invention, designated as 830, and further aligned with a second substrate 840 having a capture pad 845 disposed on its face 848. The components 810, 820, and 840 are then appropriately stacked and laminated or otherwise affixed to each other. The present invention assemblies do not require a one-to-one dedication between a capture pad, filled via, or filled aperture.

The present invention also provides a single lamination process. That is, when forming a multiple layer electronic assembly, the components need only be subjected to a single laminating operation. Typically, this results in the multilayer assembly being subjected to the relatively high laminating temperatures only once. Multiple or sequential laminating operations, as are required by the prior art when forming blind and buried vias, are not necessary.

Assembly or manufacturing of the multilayer electronic assembly of the present invention having vias or apertures filled with the compositions described herein is preferably completed by a vacuum assisted lamination process as follows. One or more circuit boards and one or more interposers having vias and apertures filled with the composition, are placed in a lamination press. A vacuum is formed within the lamination press. Pressure within the press is preferably about 1 mm Hg. Once having formed a vacuum about the electronic assembly, laminating pressure is applied to the electronic assembly, maintained under vacuum, within the press. Lamination pressure or compressive force is applied to the electronic assembly in a direction generally perpendicular to the planar boards, interposers, and other layers constituting the assembly. It is preferred that the lower limit for the lamination pressure be sufficient to cause the flowable materials in the assembly to flow, or flow when heated, and which forces air or other volatiles from the assembly and conductive composition. Preferably, the lamination pressure should be high enough to cause the adhesive materials to flow and to assist in sintering. Where lamination is performed under vacuum, i.e. vacuum assisted, the minimum lamination pressure is about 10 psi. The maximum lamination pressure is a pressure which achieves the foregoing objectives, yet which does not result in damage to the assembly. This maximum upper lamination pressure is generally dictated by the rigidity and strength of the assemblies under manufacture.

Once the desired lamination pressure or force has been applied to the assembly, i.e. at least about 10 psi, while the assembly is maintained under vacuum in the press, a heating step is initiated. It is generally preferred to heat the electronic assembly, while under vacuum and application of a lamination force, to a temperature at which the composition described herein forms a transient liquid phase. As previously noted this is from about 20°C to about 400°C, and preferably from about 180°C to about 325°C when the composition utilizes copper, tin, and lead. The upper temperature of about 400°C is generally limited by the interposer material flow or cure characteristics.

Once the lamination temperature is reached, that temperature is maintained or held for a particular time period which is primarily a function of the interposer material and electrically conductive composition utilized in the electronic assembly. Typical hold times range from about 5 minutes to about 1 hour. It is preferred that the organic component of the composition cures during lamination, although a post-lamination curing step could be added to the process if necessary.

After maintaining the electronic assembly under vacuum, at the previously described temperatures and laminating pressures, for the noted time period, the assembly is allowed to cool, preferably to room temperature. It is important that the lamination pressure is maintained until the assembly has at least cooled below the glass transition temperature of the flowable materials.

Upon cooling, lamination pressure and vacuum are released and the laminated assembly removed from the press.

The previous process description is with reference to a Pasadena Hydraulics, Inc. press, model B256-C-X1-3-5-20 with electric heat, water cooling, and a Wabash Metal Products Company press model 3-8 with electric heat, and water cooling. A custom vacuum bagging means was adapted for use with both aforementioned presses. Although the foregoing preferred process has been described utilizing a vacuum assist, the methods of the present invention do not require such vacuum assist.

Depending upon the selection of interposer and via fill material, it should be possible to produce multilayer structures with a time/temperature/pressure profile similar to a "Hot Bar" operation known to those skilled in the art. Such Hot Bar operations, as will be understood, are highly localized, site specific laminating techniques.

The compositions of the present invention may undergo both reactive sintering and/or non-reactive sintering to form electrically conductive microstructures. The resulting intermetallic or same metal bonds gives the microstructures a performance which may include intermetallic characteristics or unalloyed characteristics. The present invention processes can be tailored and ingredients in the composition selected so that the composition undergoes reactive sintering, nonreactive sintering, or varying degrees of both.

The compositions of the present invention provide a microstructure comprising a metallurgical bond formed by applying heat and pressure to a metal powder or composition containing such. Surface energy driven surface diffusion results in material transport to the points of particulate contact, resulting in the growth of a neck of material connecting the two particles. Metal-to-metal bonding without the formation of a compound (intermetallic or otherwise) at the bond neck is defined for the purposes of this disclosure as non-reactive sintering. Non-reactive solid state sintering requires temperatures on the order of one-half the absolute melting point of the materials involved to proceed at a suitable rate.

The sintering temperature can be reduced substantially by the presence of a liquid phase due to enhanced diffusion. Critical factors to consider in this regard are the ability of the liquid phase to wet the solid, the ability of the liquid to form intermetallics with the solid phase (which may cause a shift towards reactive sintering), the solubility of the solid in the liquid phase and the liquid in the solid phase and the ratio of the solid-solid and the solid-liquid surface energies.

The preferred method of bonding and forming an electrically conductive microstructure involves reactive sintering. For the purposes of this disclosure, reactive sintering is defined as a sintering process where compound formation within inter-particle bonds consumes one or more components of the original mixture. For example, copper may be bonded with tin using reactive sintering. Some or all of the tin and copper originally present may be consumed in the formation of copper-tin intermetallic bonds that bind original copper and tin particles together. The thermal and mechanical properties of the intermetallic are very different from the starting copper and tin materials. Such an intermetallic bond can be formed entirely by solid state diffusion. However, raising the temperature above the melting point of one of the constituents greatly accelerates the diffusion process. To lower the temperature at which this rapid diffusion process occurs, one of the intermetallic forming elements (tin, in this case) can be alloyed with one or more materials that will form a lower melting phase. Examples may be found in Table 1. In this case, the final metallurgical bond would consist of copper tin intermetallics plus the residual alloying element. It is also possible to utilize a reactive sintering technique in which all or a part of a copper or tin component is consumed and a portion of the tin or copper component is left remaining.

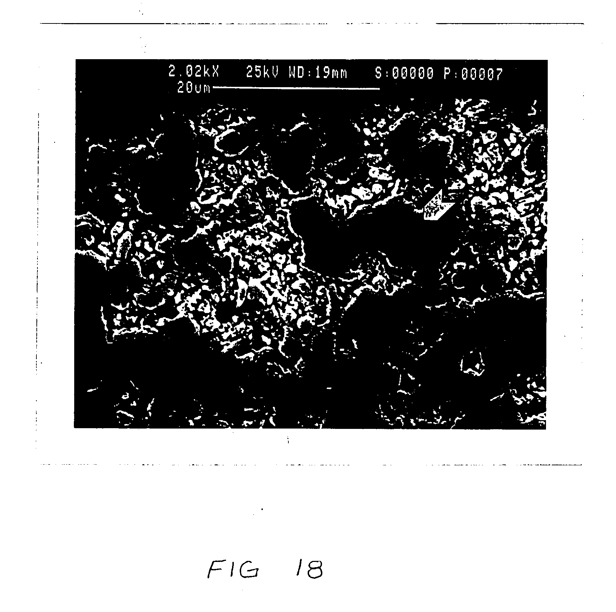

FIG. 18 is a micrograph illustrating an electrically conductive microstructure comprising a substantially monolithic intermetallic phase formed from (i) at least one high melting particulate phase material, and (ii) at least one low melting material. This micrograph illustrates the extensive intermetallic phase formed from a composition of the present invention comprising (i) copper particles having a size ranging from about 0.5 microns to about 15 microns, and (ii) a eutectic mixture of tin and lead in the form of particles having a size ranging from about 1 to about 20 microns. The molar ratio of copper to tin was 1.2:1. The amount of (i) and (ii) in the composition was about 87% by weight. It can be seen that the intermetallic phase is monolithic, or substantially so, with few structural interruptions or discontinuities.

It has been surprisingly discovered that the most preferred electrically conductive compositions of the present invention after sintering and curing, generally have a greater degree of electrical and structural continuity than known prior art compositions. When compared to prior art cured compositions, the resulting microstructure contains a continuous phase of copper tin intermetallic compound. This structure provides for a very robust electrical connection between opposing capture pads and is stable toward high temperature exposure such as may be encountered in assembly operations subsequent to lamination.

Example 1 describes a preferred composition, and its preparation, according to the present invention. Examples 2 and 3 demonstrate multilayer electronic assemblies utilizing the conductive composition of Example 1. Example 4 demonstrates an additional via fill material, and its preparation. Example 5 describes a most preferred via fill material. Example 6 describes a multilayer electronic assembly in accordance with the invention, utilizing the composition described in Example 4. Example 7 describes a preferred electrically conductive composition of the invention which does not out-gas during lamination and curing operations when forming a laminate or multilayer electronic assembly. Example 8 demonstrates a dual layer electronic assembly according to the invention utilizing the composition of Example 7. Example 9 describes forming a six metal layer structure using the composition of Example 4. Example 10 describes forming a laminate using the composition of Example 1.

### Example 1

A via fill material according to the invention, exhibiting both reactive and non-reactive sintering was produced as follows. 1.3 grams of flux was prepared from Alpha 611 RMA flux supplied at 37 percent in alcohol by staging at 82°C to remove 60 +/- 1% of the volatile content. 7.8 grams (7.8 weight percent) of a 70% solids resole phenolic resin (Oxychem Methylon 75108™) were mixed with the 1.3 grams of flux. 30.3 grams of nominally 10 micron 63/37 tin/lead solder particles and 60.6 grams of -325 mesh spherical copper particles were dispersed in the resin flux mixture. The copper powder was first reduced in forming gas at approximately 315°C for one hour to insure cleanliness. Approximately 0.5 grams of benzyl alcohol was added to adjust the viscosity to a value suitable for screen printing.

### Example 2

A 6-metal layer interconnect structure was fabricated from single sided circuit layers using the via fill material from Example 1 as follows. Single sided circuits were produced from copper foil adhesively bonded to polyimide film by standard subtractive etching techniques. The polyimide film was DuPont Kapton H™ and the adhesive was DuPont Pyralux™. The foil was rolled and annealed one ounce copper. The copper/adhesive/Kapton material was packaged under the trade name Pyralux LF-9120. Artwork corresponding to the circuit pattern desired on each of the 6 metal circuit layers was produced and used to expose the photoresist coated Pyralux LF material. The photoresist was developed and the exposed copper was etched using a ferric chloride-based etchant. The photoresist was removed and a modified epoxy adhesive sheet was heat tacked to the dielectric side of the panel containing the etched circuits. The adhesive was 1 mil Courtalds Z-Flex™ supplied on 1 mil mylar release sheet. The individual circuit layers were excised from the panel and both 4 mil and 8 mil diameter vias were punched through lands in the copper traces using a numerically controlled punch. Punch-to-die clearances were closely controlled to produce vias of the highest quality. The circuit and via pattern were chosen to demonstrate stacked, blind and buried bias in the final structure. Each via punched circuit layer was then via filled with the via fill material from Example 1, as follows. The circuit was placed on the vacuum nest of the screen printer, circuit side down. Using the via punched mylar as a contact mask and using screen printer parameters familiar to those skilled in the art, the vias were filled with the via fill paste.

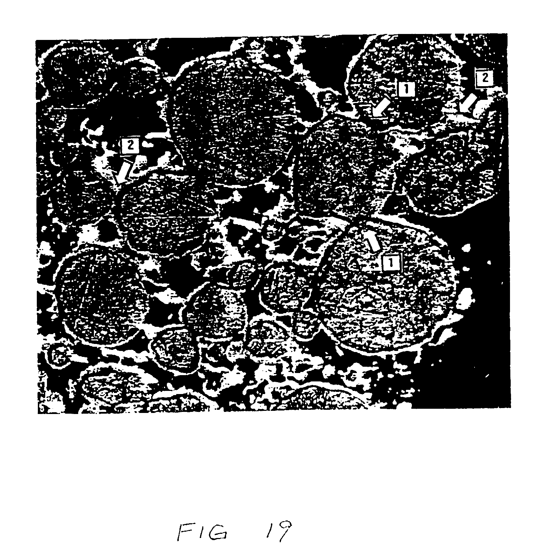

The via filled laminates were then assembled into multilayered circuits. The individual via filled circuit layers were stacked in a lamination fixture that ensures alignment of the individual layer vias. The lamination schedule consists of pressure cycling between 500 and 1000 psi at room temperature to de-air the laminate, followed by pressure reduction to 250 psi. The press platens are then heated to approximately 194°C over a period of 20-25 minutes. The system was held at temperature and pressure for 70 minutes and then cooled to room temperature over a period of 15 minutes while being held at lamination pressure. The completed structure contained blind, buried and stacked vias of both 4 mil and 8 mil diameter in larger lands. The stacked 4 mil vias had a resistance of less than 50 milliohms. Cross sections of the vias are shown in FIG. 19 and illustrate both reactive and non-reactive sintering. The locations of the photograph labelled by the numeral 1 are copper bonds, while those labelled as 2 are intermetallic bonds.

### Example 3

A four metal layer structure was fabricated from double-sided circuits with plated throughholes using the via fill material from Example 1 as follows. The double-sided circuits were produced by vacuum metallizing one side of a copolymer polyimide (Upilex) with a "seed" layer of chrome/copper, punching the via pattern, then vacuum metallizing the second side and the vias. Photoresist was laminated to both sides and developed in such a fashion as to expose the seed layer in areas where copper metal was desired. Copper was plated up electrolytically. When the desired thickness of copper was reached, the photoresist was stripped and the seed layer was flash etched. The resulting circuits were approximately 6" x 6" and contained approximately 1.6 mil lines separated by 1.8 mil spaces on the first side and a substantially continuous copper ground plane on the second side. More than two thousand five hundred 2.5 mil diameter metallized vias connected the two sides.

Structures containing four metal circuit layers with stacked vias were fabricated from pairs of the double-sided circuits by interleaving bond plies between the double-sided circuits. The bond plies were fabricated by first laminating adhesive and a release sheet to both sides of Upilex film. The adhesive was Courtalds Z-Flex™ 1 mil thick on a release sheet of polyester (Mylar™). The same via pattern present in the double-sided circuit flex was punched in the bondply with an 8 mil punch. An 8 mil, rather than 2 or 4 mil punch, was used simply for reasons of convenience. The same 8 mil via pattern was also punched in a 2 mil metal foil creating a metal stencil for via filling.

The bondply and circuit layers were placed on the vacuum nest of a screen printer. The via pattern in the metal stencil was registered to the bondply or circuit via pattern. Via fill material from Example 1 was applied to the stencil and, using screen printing parameters familiar to those skilled in the art, a via paste was printed into the bondply or circuit vias.

Three kinds of multilayer assemblies were fabricated. Via filled circuits were laminated with via filled bond plies to a metal stiffener to form the first assembly. Unfilled circuits were laminated with via filled bond plies without a stiffener to form the second assembly. Via filled circuits were laminated with via filled bond plies without a stiffener to form the third kind of assembly. In all cases, the lamination schedule consisted of pressure cycling the stack between 500 and 1,000 psi at room temperature to de-air the laminate followed by a pressure reduction to 250 psi. The press platens were then heated to 194°C over a period of 25 minutes. The system was held at temperature and pressure for 70 minutes and then cooled to room temperature over a period of 15 minutes, while being held at lamination pressure.

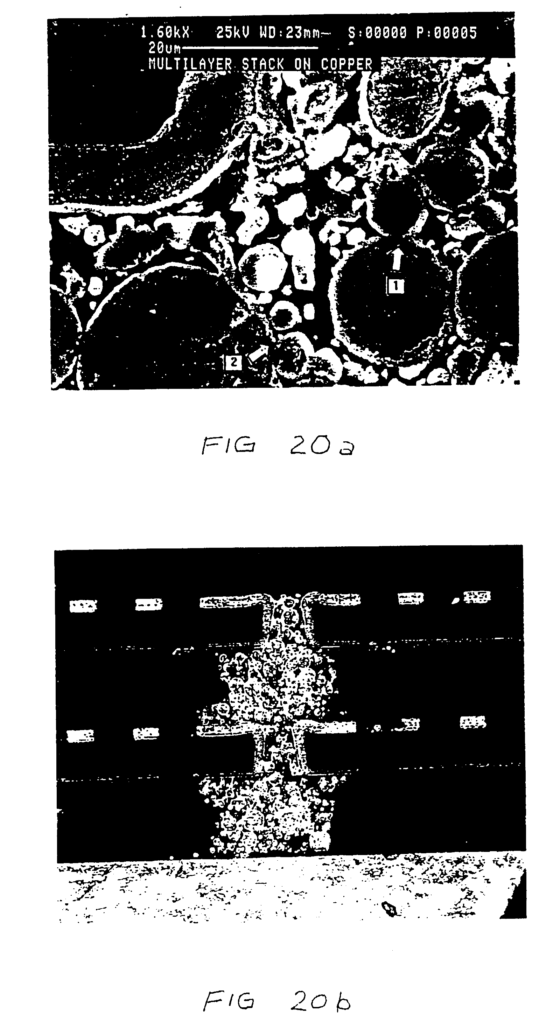

The completed laminates contain vias. FIG. 20a shows that the vias were formed by both non-reactive and reactive sintering, as shown at 1 and 2 respectively, and FIG. 20b shows a view of the structure from lower magnification, where the via and circuit layers are visible.

### Example 4

A via fill material according to the present invention was prepared as follows. A mixture of 84.3% by weight of Shell Epon 828 epoxy resin and 15.7% by weight of malic acid was heated on a hotplate set to 150°C until the solution became clear. 2.3 grams of dodecenylsuccinic anhydride was added to 2.7 grams of the above mixture and stirred. 7.7 grams of spherical copper powder, of a particle size distribution where 90% of the particles are less than 6 microns with a mean of 3 microns was added and stirred with a spatula. The copper powder was first reduced in forming gas at approximately 315°C for 15 minutes. The copper mixture was then blended on a laboratory roller mill to disperse and reduce the agglomerates in the copper powder. 16.6 grams of 63/37 tin/lead solder powder, with particle size of -10 micron, were added to 9.2 grams of the copper mixture and blended with a high speed mixer. The resulting paste was vacuumed for 15 minutes at room temperature in order to remove trapped air.

### Example 5

A most preferred embodiment via fill material was prepared as follows. A mixture of 84.3% by weight of Shell Epon 828 epoxy resin and 15.7% by weight of malic acid was heated on a hotplate set to 150°C until the solution became clear. 0.9 grams dodecenylsuccinic anhydride was added to 2.0 grams of the above mixture and stirred. 4.4 grams of spherical copper powder, as described in Example 4, was added and stirred with a spatula. The copper mixture was then blended on a laboratory rollermill to disperse and reduce the agglomerates in the copper powder. 9.1 grams of 63/37 tin/lead solder powder as described in Example 4, were added to 5.0 grams of the copper mixture and blended with a high speed mixer. The resulting phase was vacuumed for 15 minutes at room temperature in order to remove trapped air.

### Example 6

A four metal layer structure was fabricated from double-sided circuits with plated throughholes using the via fill material from Example 4 as follows.

The double-sided circuits were manufactured by Sheldahl from Novaclad® flexible circuit material. The circuit layers were patterned with throughholes, some of which were plated shut. The circuits consisted of 2 mil lines and 2 mil spaces and 4 and 6 mil vias. A structurewith 4 metal circuit layers was fabricated from pairs of the double-sided circuits by interleaving bond plies between the double-sided circuits. The bondply material was DuPont 300KJ, a 3 mil thick thermoplastic polyimide film. The same via pattern present in the double-sided circuit flex was punched in the bondply with a 4 mil punch.

The bondply layer was placed on the vacuum nest of the screen printer. The via pattern in the metal stencil was registered to the bondply via pattern. Via fill material from Example 5 was applied to the stencil and, using screen printing parameters familiar to those skilled in the art, the via paste was printed into the bondply vias.

The assembly was stacked with 2 unfilled double-sided circuit pairs interleaved with a filled bondply layer and laminated in a hydraulic press. The lamination schedule consisted of heating the press platens to 300°C over a period of 25 minutes under 400 psi pressure. The system was held at temperature under 400 psi pressure for 30 minutes and then cooled to room temperature over a period of 30 minutes, while being held at lamination pressure.

The completed laminates contain electrically conductive vias, all of which have a resistivity of less than 50 micro ohm centimeters.

### Example 7

A preferred via fill material was prepared as follows. A mixture of 81.9% Shell Epon 828 epoxy resin and 18.1% by weight of malic acid was roller milled until the malic acid was milled and blended with the resin to a milky appearance. 3.6 grams of copper powder as described in Example 4 was added to 2.4 grams of the above resin mixture. The copper mixture was then blended on a laboratory roller mill to disperse and reduce the agglomerates in the copper powder. 7.2 grams of 63/37 tin/lead solder powder as described in Example 4, were added to 3.9 grams of the copper mixture and blended with a high speed mixer. The resulting paste was vacuumed for 15 minutes at room temperature in order to remove trapped air.

### Example 8

Structures with two circuit layers interconnected with bondply layer using via fill material from Example 7 were fabricated as follows. The single-sided circuits were manufactured by Sheldahl from Novaclad flexible circuit material. The circuits were patterned with 4 grids of daisy chain segments consisting of pairs of 6 or 10 mil pads connected with 6 mil traces and designed such that the segments were connected electrically from the circuit layers through vias in the bondply layers. The bondply material was a composite laminate of 1 mil thick thermosetting polyimide adhesive heat tacked to both sides of 1 mil DuPont Kapton®. A via pattern was punched with 4 and 6 mil holes in the bond plies such that the 6 mil vias aligned with the 10 mil pads on the circuit plies and the 4 mil vias aligned with the 6 mil pads on the circuit plies. There were 2,400 vias total and 600 vias in each of the 4 daisy chain grids per bondply.

The bondply layers were placed on the vacuum nest of the screen printer. The via pattern in the metal stencil was registered to the bondply via pattern. Via fill material from Example 7 was applied to the stencil and, using screenprinting parameters familiar to those skilled in the art, the via paste was printed into the bondply vias.

The assemblies were stacked with 2 single-sided circuit plies interleaved and aligned with a filled bondply layer and laminated in a hydraulic press. The lamination schedule consisted of heating the press platens to 200°C over a period of 25 minutes under 300 psi pressure. The system was held at temperature under 300 psi pressure for 1 hour and then cooled to room temperature over a period of 30 minutes, while being held at lamination pressure.

Initial resistance values were read for the daisy chains in each laminate. The assemblies were subjected to air-to-air thermal shock testing, -55°C to 125°C, 3 cycles per hour, for 2,000 cycles and completed the test with less than 5% change in resistance.

### Example 9

A six metal layer structure was fabricated from double-sided circuits with plated throughholes using the via fill material from Example 4 as follows.

A structure with 6 metal circuit layers was fabricated from pairs of the double-sided circuits by interleaving bond plies between the double-sided circuits. The double-sided circuits were manufactured by IBM. The circuits were designed with 20 mil center grids of vias with three types of via/land patterns: 4 mil holes in 4 mil lands, 4 mil holes in 6 mil lands, and 6 mil holes in 10 mils lands. All holes were the punched size before plate-up. Each via hole/land type above was implemented in three subgrids of 480 via connections each of a stacked (connects layer 1 through layer 6), buried (connects layer 2 through layer 5), and blind (connects layer 1 through layer 5) configuration.

The bondply material was a composite laminate of 1 mil thick thermosetting polyimide adhesive heat tacked to both sides of 1 mil DuPont Kapton®. A via pattern was punched in the bond plies with 4 and 6 mil vias such that the 6 mil vias aligned with the 6 mil vias or 10 mil pads on the circuit layers and the 4 mil vias aligned with the 4 mil vias on 4 or 6 mil lands on the circuit layers. The bond plies and circuit layers were individually placed on the vacuum nest of the screen printer. Metal stencils were punched with the via pattern for each ply. The via patterns in the metal stencils were registered to the corresponding via patterns in the bondply and circuit layers. Via fill from Example 4 was applied to the stencils and, using screen printing parameters familiar to those skilled in the art, the via paste was printed into the bondply vias. The plies were then staged in a nitrogen atmosphere for 30 minutes at 100°C.

The plies were stacked with 3 double-sided circuit plies interleaved and aligned with filled bondply layers and laminated in a hydraulic press. The lamination schedule consisted of heating the press platens to 200°C over a period of 25 minutes under 300 psi pressure. The system was held at 200°C and 300 psi pressure for 1 hour and then cooled to room temperature over a period of 30 minutes, while being held at lamination pressure.

Initial resistance values were read for the 9 daisy chain grids in the laminate. The assemblies were subjected to a variety of accelerated tests. One assembly was air-to-air thermal shock tested from -40 to 135°C, for 1,000 cycles and completed the test with no increase in resistance in all of the grids. A second assembly was exposed to 1,000 cycles of air to air thermal shock from -55 to 125°C with similar results. A third assembly was exposed to 300 cycles liquid to liquid thermal shock from -55 to 125°C with similar results.

### Example 10

Structures with two metal layers interconnected with a bondply layer using via fill material from Example 1 were fabricated as follows. Sheets of untreated 1 ounce copper were laminated to both sides of a bondply layer patterned with 8 mil vias and filled with the via fill composition from Example 1. The bondply material was a 3 mil construction of 1 mil of Courtauld's Z-flex adhesive coated onto both sides of 1 mil polyimide film. The bondply was supplied with 1 mil polyester (Mylar™) release film tacked to both adhesive surfaces. Sheets of the bondply were blanked to 5"x5" and punched with 8 mil holes in a grid pattern spaced 0.45" apart. The plies were taped to a screen printing nest and using the via punched release sheet as a contact mask and using screen printing parameters familiar to those skilled in the art, the vias were filled with the via fill paste. The release sheets were then removed from both sides of the bondply.

A filled bondply was then stacked in a lamination fixture between 5"x5" sheets of untreated 1 ounce copper and laminated in a hydraulic press. The press platens were heated to 200°C over a period of 25 minutes. The system was held at 200°C for a period of 60 minutes and then cooled to room temperature over a period of 15 minutes, while being held at lamination pressure.

The copper on one side of the laminate was chemically etched in a grid pattern of capture pads such that each pad was in contact with one via and made electrical connection to the via and through the bondply layer to the copper sheet on the other side of the bondply.

The completed laminate contained 223 vias with connections from the bottom copper plane to the individual capture pads.

## Claims

1. A composition adapted for forming an electrically conductive microstructure, characterised in that the composition comprises: at least one high melting particulate phase material; at least one low melting material; and an organic portion comprising a resin and a cross-linking agent.

2. A composition as claimed in Claim 1, characterised in that the high melting particulate phase material is selected from all metals from group 3A to 6B of the periodic table excluding Hg, Ga and In, for example copper, nickel, gold, silver or combinations thereof.

3. A composition as claimed in Claim 1 or Claim 2, characterised in that the high melting material is copper and the low melting material comprises an agent selected from: dysprosium, erbium, europium, gallium, gadolinium, germanium, hafnium, mercury, indium, lanthanum, magnesium, neodymium, phosphorus, palladium, praseodymium, platinum, sulfur, selenium, antimony, silicon, samarium, tin, strontium, tellurium, thorium, titanium, thallium, yttrium, ytterbium, zinc, zirconium, and combinations thereof.

4. A composition as claimed in Claim 1 or Claim 2, characterised in that the low melting material is tin or a tin bearing alloy.

5. A composition as claimed in Claim 1, characterised in that the high melting particulate phase material is copper, the low melting material is tin or tin bearing alloy, and the molar ratio of the copper to the tin ranges from 3:1 to 0.9:1.

6. A composition as claimed in Claim 1, characterised in that the high melting particulate phase material comprises copper particles having an average particle diameter of from 1 to 6 µm, the low melting material comprises eutectic tin/lead alloy particles having an average particle diameter of from 1 to 10 µm, and the organic portion comprises epoxy, dodecenylsuccinic anhydride, and malic acid.

7. A composition as claimed in any preceding Claim, characterised in that the resin is an epoxy, preferably diglycidyl ether of bisphenol A.

8. A composition as claimed in any preceding Claim, characterised in that the high melting particulate phase material represent from 2 to 90% by weight, the low melting material represents from 4 to 93% by weight and the resin an cross-linking agent in combination represent from 1 to 35% by weight.

9. A composition as claimed in Claim 8, characterised in that the high melting particulate phase material constitutes from 10 to 90% by weight of the composition, the low melting material constitutes from 10 to 90% by weight of the composition ,and the resin and cross-linking agent constitute from 3 to 30% by weight of the composition.

10. A composition as claimed in Claim 8, characterised in that the high melting particulate phase material is copper and constitutes from 17 to 47% by weight of the composition and the low melting material is eutectic mixture of tin and lead which constitutes from 37 to 72% by weight of the composition, and optionally the resin and cross-linking agent constitute from 5 to 25% by weight of composition.

11. A composition as claimed in any of Claims 8 to 10, characterised in that the composition forms a microstructure comprising a substantially continuous intermetallic phase.

12. A composition as claimed in any of Claims 1 to 7, characterised in that it comprises: particulate copper or copper bearing alloy and particulate tin or tin bearing alloy selected in appropriate proportions to enable the formation of a substantially continuous phase of copper-tin intermetallic compound in the microstructure; and from 5 to 25% by weight of a combination of at least one resin and at lest one cross-linking agent.

13. A composition as claimed in Claim 12, characterised in that the composition forms the substantially continuous phase of copper-tin intermetallic compound in the microstructure at least in part by a transient liquid phase process.

14. An electrically conductive microstructure suitable for forming a filled via or filled aperture in an electronic assembly, characterised in that the microstructure comprises an intermetallic phase formed from at least one high melting particulate phase material and at least one low melting material, the intermetallic phase preferably being substantially monolithic.

15. A microstructure as claimed in Claim 14, characterised in that the substantially monolithic intermetallic phase is formed at least in part by a transient liquid phase comprising said at least one low melting material.

16. A microstructure as claimed in Claim 14 or Claim 15, characterised in that the high melting particulate phase material is selected from copper, nickel, gold, silver, or combinations thereof, and optionally, the low melting material is tin or a tin bearing alloy.

17. A microstructure as claimed in Claim 16, characterised in that the microstructure has an electrical resistivity of less than 50 micro ohm centimetres.

18. A microstructure as claimed in Claim 16 or Claim 17, characterised in that the high melting particulate phase material is copper particles having an average diameter of from 1 to 6 µm, and the molar ratio of the copper to the tin ranges from 3:1 to 0.9:1.

19. A microstructure as claimed in any of Claims 16 to 18, characterised in that it comprises a copper-tin intermetallic compound which constitutes at least a majority of the microstructure, and preferably constitutes substantially all of the microstructure.

20. A microstructure as claimed in Claim 19, characterised in that the intermetallic compound is selected from Cu₃Sn, Cu₆Sn₅, and combinations thereof.

21. A substrate having an electrically conductive pathway extending through the substrate for providing electrical connection from one face of the substrate to another face of the substrate, the substrate defining a passageway extending through the substrate from the said one face to the said other face, characterised by an electrically conductive microstructure as claimed in any of Claims 14 to 20 in the passageway.

22. A substrate as claimed in Claim 21, characterised in that the high melting particulate phase material is copper and the low melting material is tin and the ratio of the copper to the tin ranges from 3:1 to 1.2:1.

23. A substrate as claimed in Claim 21 or Claim 22, characterised in that the substrate has a capture pad or a circuit trace disposed on the said one face, the capture pad or circuit trace being in electrical contact with the microstructure.

24. A substrate as claimed in Claim 21, comprising a first face, a second face, and an electrically conductive coating disposed on the first face and/or the second face, the passageway extending through the substrate from the first face to the second face, characterised in that the electrically conductive microstructure disposed in the passageway is produced from a composition as claimed in any of Claims 8 to 11.

25. A substrate as claimed in Claim 21, characterised in that the microstructure comprises a substantially continuous intermetallic phase of copper-tin intermetallic compound produced from a composition as claimed in Claim 12 or Claim 13.

26. An electronic assembly comprising a dielectric layer defining at least one passage extending through the thickness of the said layer and a composition disposed within the passage, characterised in that the composition comprises a composition as claimed in any of Claims 8 to 11.

27. An assembly as claimed in Claim 26, characterised in that the composition produces the electrically conductive microstructure with a substantially continuous intermetallic phase upon sufficient heating of the composition under a pressure of at least 10 psi.

28. An assembly as claimed in Claim 26 or Claim 27, in which the dielectric layer has a first face, a second face opposite the first face, and a plurality of passages extending through the dielectric layer, characterised in that the assembly further comprises: an electronic component disposed on the first face of the dielectric layer, the electronic component having one or more points on its underside for electrical connection thereto; and a substrate disposed proximate to the second face of the dielectric layer, the substrate having one or more capture pads corresponding to the points on the underside of said electronic component and in which the composition is disposed in the plurality of passages defined in the dielectric layer.

29. An assembly as claimed in Claim 28, characterised in that the composition disposed in the plurality of passages defined in the dielectric layer provides electrical connection between the points for electrical connection of the electronic component and the capture pads of the substrate.

30. An assembly as claimed in Claim 28 or Claim 29, characterised in that the dielectric layer is a film adhesive which, after appropriate heating, physically affixes the electronic component to the substrate.

31. An electronic assembly comprising: a dielectric layer defining at least one passage extending through the thickness of the layer; and a composition disposed within the passage, characterised in that the composition is a composition as claimed in Claim 12 or Claim 13, and the substantially continuous phase of copper-tin intermetallic compound is attained upon sufficient heating of the composition under a pressure of at least 10 psi (68.9 kPa).

32. A multilayer electronic assembly comprising: a first dielectric circuit board defining a first via extending through the first board; a second dielectric circuit board defining a second via extending through the second board; an interposer layer disposed between the first circuit board and the second circuit board, the interposer layer defining an aperture through the interposer, wherein the first via, the second via, and the aperture are all aligned and disposed immediately adjacent to each other; and an electrically conductive microstructure disposed within at least one of the first via, the second via, and the aperture; characterised in that the microstructure is formed from a composition as claimed in any of Claims 8 to 11.

33. A multilayer electronic assembly comprising: a first dielectric circuit board defining a first via extending through the first board; a second dielectric circuit board defining a second via extending through the second board; an interposer layer disposed between the first circuit board and the second circuit board, the interposer layer defining an aperture through the interposer, wherein the first via, the second via, and the aperture are all aligned and disposed immediately adjacent to each other; and a sinterable composition disposed within at least one of the first via, the second via, and the aperture; characterised in that the composition is a composition as claimed in Claim 12 or Claim 13 wherein upon sufficient heating, the composition produces a microstructure comprising a substantially continuous intermetallic phase.

34. An assembly as claimed in Claim 33, characterised in that the composition is disposed in the aperture defined in the interposer layer and optionally in the first via defined in the first dielectric circuit board.

35. An assembly as claimed in Claim 33 or Claim 34, characterised in that the first via and/or the second via is a plated via, and optionally, the or each plated via is a closed plated via.

36. An assembly as claimed in Claim 35, characterised in that the first plated via and/or the second plated via has the composition disposed therein.

37. An assembly as claimed in Claim 33, characterised by an electrically conductive capture pad disposed around the periphery of the first via and/or the second via.

38. A multilayer electronic assembly comprising: a plurality of circuit boards disposed in a stacked configuration in which each board generally overlies an adjacent board, and at least one of the boards defines a via extending through that board; at least one interposer layer disposed between two of the circuit boards, in which the interposer layer defines an aperture extending through the interposer; and an electrically conductive microstructure disposed in the via and/or the aperture; characterised in that the microstructure is formed from a composition consisting essentially of a high melting particulate phase, a low melting material, and an organic portion comprising an epoxy resin, a cross-linking agent, and a cure-flux agent, and in which the organic portion does not generate adverse amounts of volatile gases upon heating to a temperature of 400°C at a pressure of at least 10 psi (68.9 kPa).

39. An assembly as claimed in Claim 38, characterised in that the plurality of circuit boards includes a first board having the via, a second board comprising an electrically conductive capture pad, and the aperture defined in the interposer layer has the composition disposed therein.

40. An electronic assembly comprising a dielectric circuit board defining a via extending through the thickness of the board and an interposer layer disposed adjacent the circuit board, the interposer layer defining an aperture extending through the interposer, characterised by an electrically conductive microstructure as claimed in any of Claims 14 to 18 disposed in the via and/or the aperture, the tin or tin bearing alloy optionally being in the form of particles having an average diameter of from 1 to 10 µm.

41. An electronic assembly comprising: a dielectric circuit board defining a via extending through the thickness of the board; an interposer layer disposed adjacent the circuit board, the interposer layer defining an aperture extending through the interposer; and an electrically conductive microstructure disposed in the via and/or the aperture, characterised in that the microstructure is as claimed in Claim 19 or Claim 20.

42. An electronic assembly comprising: a first dielectric substrate comprising a first electrically conductive capture pad on a face of the first substrate; a second dielectric substrate comprising a second electrically conductive capture pad on a face of the second substrate; and an interposer layer positioned between the first substrate and the second substrate, the interposer layer defining at least one aperture; characterised by an electrically conductive microstructure as claimed in any of Claims 14 to 20 disposed in at least one aperture defined in the interposer.

43. An assembly as claimed in Claim 42, characterised in that the first capture pad, the second capture pad, and at least one aperture having the microstructure disposed therein are aligned with each other and form an electrically conductive pathway.

44. An assembly as claimed in Claim 42 or Claim 43, characterised in that the interposer layer defines a plurality of apertures, all of which have the microstructure disposed therein.

45. A process for forming a stacked multilayer electronic assembly comprising at least one circuit board, at least one interposer layer, and at least one electrically conductive microstructure extending through the interposer and to an adjacent surface of the board, the process comprising: providing at least one circuit board and at least one interposer layer, the interposer defining an aperture extending through the interposer; filling the aperture with an electrically conductive composition comprising a high melting particulate phase material, a low melting material, and an organic portion having a resin and a cross-linking agent; placing the circuit board and interposer in a stacked configuration within a laminating press; applying a lamination force to the assembly; heating the assembly to a laminating temperature while maintaining the laminating force; and maintaining the laminating temperature until the electrically conductive composition cures, whereby the composition produces an electrically conductive microstructure.

46. A process as claimed in Claim 45, characterised by forming a vacuum about the circuit board and interposer in their stacked configuration in the laminating press.

47. A process as claimed in Claim 46, characterised in that the vacuum formed about the stacked configuration is about 1 mm HG (133 Pa) and/or the laminating force is at least 10 psi (68.9 kPa).

48. A process as claimed in any of Claims 45 to 47, characterised in that the laminating temperature ranges from 20°C to 400°C, more preferably from 180°C to 325°C, and is optionally maintained for a time period of from 5 minutes to 1 hour.

49. A process as claimed in any of Claims 45 to 48, characterised in that the multilayer assembly is subjected to the laminating temperature only one time during the said process.

50. A process as claimed in any of Claims 45 to 49, characterised in that the composition comprises: from 2 to 90% preferably 10 to 90% by weight of the high melting material; from 4 to 93% preferably 10 to 90% by weight of the low melting material; and from 1 to 35% preferably 3 to 30% by weight of the organic portion.

51. A process as claimed in any of Claims 45 to 50, characterised in that the microstructure comprises a substantially continuous intermetallic phase.

52. A process as claimed in Claim 51, characterised in that the composition comprises particulate copper or copper bearing alloy and particulate tin or tin bearing alloy selected in appropriate proportions to result in a substantially continuous phase of copper-tin intermetallic compound in the microstructure, and from 5 to 25% by weight of a combination of at least one resin and at least one cross-linking agent, and in which the resulting microstructure comprises a substantially continuous intermetallic phase, preferably formed at least in part by a transient liquid phase process.

53. A process for forming a stacked multilayer electronic assembly comprising a first substrate having conductive material disposed on at least one face, a second substrate defining a passageway extending through the second substrate from a first side to a second side, and a composition disposed in the passageway, the composition comprising a composition as claimed in any of Claims 8 to 13, the process comprising: placing the first substrate and the second substrate in a stacked configuration within a laminating press; applying a laminating force to the first and second substrates; heating the first and second substrate to a laminating temperature while maintaining the laminating force; and maintaining the laminating temperature until the composition cures to form an electrically conductive microstructure.

54. A multilayer electronic assembly formed by the process of any of Claims 45 to 53.
